# FASCICULE DE BREVET EUROPEEN

(11) **EP 3 503 105 B1**
(45) Date de publication et mention de la délivrance du brevet: **28.10.2020**
(21) Numéro de dépôt: 18213225.8
(22) Date de dépôt: 17.12.2018
(51) Int. Cl.: G11C 7/10, G11C 7/18, G11C 11/412, G11C 11/419, G11C 15/04

(54) **CIRCUIT MÉMOIRE PARTITIONNÉ ADAPTÉ À METTRE EN OEUVRE DES OPÉRATIONS DE CALCUL**
ADAPTIERTER PARTITIONIERTER SPEICHERSCHALTKREIS ZUR DURCHFÜHRUNG VON RECHENOPERATIONEN
PARTITIONED MEMORY CIRCUIT SUITABLE FOR PERFORMING COMPUTING OPERATIONS

(30) Priorité: 19.12.2017 FR 1762470
(43) Date de publication de la demande: 26.06.2019
(73) Titulaire: Commissariat à l'Energie Atomique et aux Energies Alternatives, 75015 Paris (FR)
(72) Inventeur: NOEL, Jean-Philippe, 38320 EYBENS (FR); BISWAS, Avishek, 38100 GRENOBLE (FR); GIRAUD, Bastien, 38340 VOREPPE (FR)
(74) Mandataire: Cabinet Beaumont

(56) Documents cités:
- JP-A- 2008 198 243
- US-A1- 2002 036 944
- US-A1- 2012 314 468
- US-A1- 2013 051 170

## Description

### Domaine

La présente demande concerne le domaine des circuits mémoire. Elle vise plus particulièrement un circuit mémoire adapté à mettre en oeuvre des opérations de calcul.

### Exposé de l'art antérieur

Il a déjà été proposé, dans la demande de brevet français N°16/54623 (DD16812/B14843) déposée par le demandeur le 24 mai 2016, un circuit mémoire adapté non seulement à stocker des données, mais aussi à effectuer, in-situ, lors d'accès au contenu de la mémoire, un certain nombre d'opérations logiques et/ou arithmétiques ayant pour opérandes des données stockées dans la mémoire. Ce circuit comprend, comme dans un circuit mémoire classique, une pluralité de cellules élémentaires agencées en matrice selon des rangées et des colonnes, et un circuit de contrôle adapté à mettre en oeuvre des opérations de lecture ou d'écriture de données dans des rangées ou des portions de rangées de la matrice. A la différence d'un circuit mémoire classique dans lequel une seule rangée de la matrice peut être sélectionnée à la fois lors d'une opération de lecture, le circuit de contrôle est adapté à sélectionner simultanément en lecture une pluralité de rangées de la matrice de façon à réaliser une opération logique ayant pour opérandes les données contenues dans les rangées sélectionnées.

Il serait souhaitable d'améliorer au moins en partie certains aspects d'un tel circuit mémoire.

La demande de brevet US2002036944 décrit des exemples de circuits mémoire intégrés.

### Résumé

La présente invention est définit par un circuit mémoire tel que définit par la revendication indépendante 1 et par un circuit mémoire tel que définit par la revendication indépendante 13.

D'autres modes de réalisation avantageux sont présentés dans les revendications dépendantes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente de façon schématique un exemple d'un module mémoire ;
la figure 2 est un schéma électrique plus détaillé d'un exemple d'une cellule élémentaire d'un module mémoire ;
la figure 3 représente de façon schématique un exemple d'un module mémoire selon un mode de réalisation ;
la figure 4 est un schéma électrique d'un exemple de réalisation d'un circuit de liaison du module mémoire de la figure 3 ;
la figure 5 représente de façon schématique un autre exemple d'un module mémoire selon un mode de réalisation ;
la figure 6 représente de façon schématique un exemple d'un circuit mémoire comprenant plusieurs modules mémoire du type décrit en relation avec la figure 5 ;
la figure 7 est un schéma électrique d'un exemple de réalisation d'un circuit de liaison du circuit mémoire de la figure 6 ;
la figure 8 représente de façon schématique un autre exemple d'un module mémoire selon un mode de réalisation ;
la figure 9 représente de façon schématique un exemple d'un circuit mémoire comprenant plusieurs modules mémoire du type décrit en relation avec la figure 8 ;
la figure 10 illustre une variante d'un module mémoire selon un mode de réalisation ; et
la figure 11 illustre une autre variante d'un module mémoire selon un mode de réalisation.

### Description détaillée

De mêmes éléments ont été désignés par de mêmes références dans les différentes figures. Par souci de clarté, seuls les éléments utiles à la compréhension des modes de réalisation décrits ont été représentés et sont détaillés. Dans la description qui suit, les références à des signaux de niveau haut et bas doivent être interprétées de façon relative, comme correspondant à deux états distincts des signaux binaires traités par les circuits décrits. A titre d'exemple, les signaux de niveau haut correspondent à des potentiels de l'ordre d'un potentiel d'alimentation haut VDD des circuits décrits (par exemple égal à VDD à 0,5 V près), et les signaux de niveau bas correspondent à des potentiels de l'ordre d'un potentiel d'alimentation bas GND des circuits décrits (par exemple égal à GND à 0,5 V près).

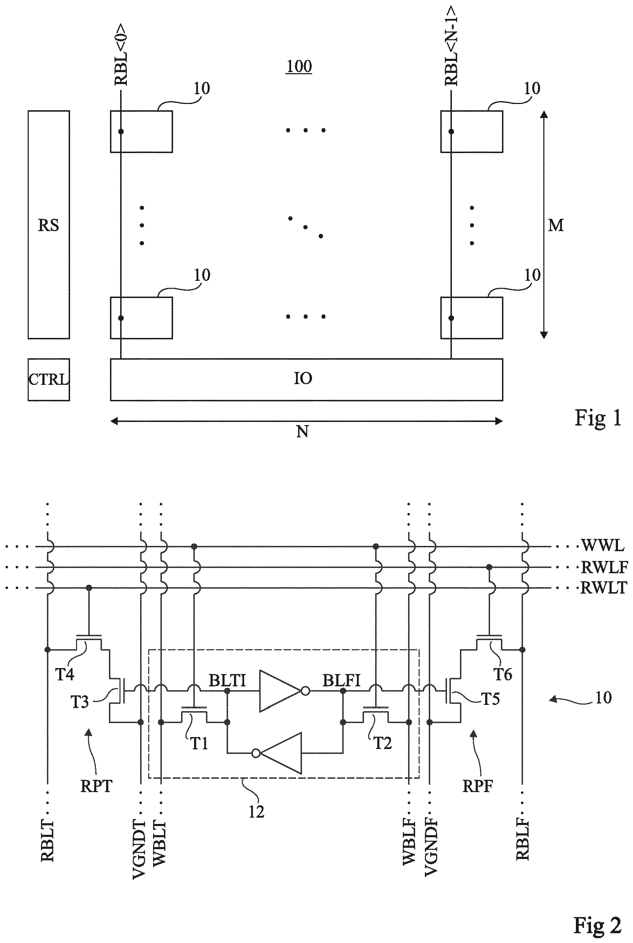

La figure 1 représente de façon schématique un exemple d'un module mémoire 100. En pratique, un circuit mémoire d'un dispositif électronique peut comprendre un ou plusieurs modules mémoire, par exemple identiques. Dans le cas d'un circuit mémoire à plusieurs modules, les différents modules peuvent être intégrés sur une même puce semiconductrice, ou sur des puces distinctes.

Le module mémoire 100 de la figure 1 comprend une pluralité de cellules élémentaires 10 agencées en matrice selon des rangées ayant une première direction (horizontale dans l'orientation de la figure 1) et des colonnes ayant une deuxième direction (verticale dans l'orientation de la figure 1). Dans l'exemple de la figure 1, la matrice comprend M rangées et N colonnes, où M et N sont des entiers supérieurs ou égaux à 2.

Chaque cellule élémentaire 10 est adaptée à mémoriser un bit de donnée. Les cellules élémentaires 10 d'une même colonne de la matrice sont connectées à une même piste conductrice de sortie ou ligne de bit de lecture RBL du module, étant entendu que les cellules élémentaires 10 de colonnes distinctes sont connectées à des lignes de bit de lecture RBL distinctes. Autrement dit, pour chaque colonne de rang j de la matrice, où j est un entier allant de 0 à N-1, le module comprend une ligne de bit de lecture RBL<j> spécifique à la colonne, connectant entre elles les cellules de la colonne. Les lignes de bit de lecture RBL<j> s'étendent dans la direction des colonnes de la matrice, c'est-à-dire verticalement dans l'orientation de la figure 1. Les lignes de bit de lecture RBL<j> sont connectées à un même circuit d'entrée-sortie IO du module, par exemple disposé à une extrémité des colonnes de la matrice.

Le module 100 comprend de plus un circuit de sélection de rangées RS, par exemple disposé à une extrémité des rangées de la matrice.

Le module 100 comprend en outre un circuit de contrôle CTRL adapté à recevoir des instructions provenant d'un dispositif externe au module, et à commander en conséquence les cellules élémentaires 10 du module via le circuit de sélection de rangées RS et/ou via le circuit d'entrée-sortie IO du module.

Dans cet exemple, le module mémoire est adapté non seulement à stocker des données, mais aussi à effectuer, in-situ, lors d'accès au contenu de la mémoire, un certain nombre d'opérations logiques et/ou arithmétiques ayant pour opérandes des données stockées dans le module. Les résultats des calculs peuvent être transmis à des circuits externes au module, et/ou être réécrits dans le module sans transiter par des circuits externes au module, et notamment par un bus de données externe au module.

La figure 2 est un schéma électrique détaillé d'un exemple d'une cellule élémentaire 10 d'un module mémoire du type décrit en relation avec la figure 1.

La cellule élémentaire 10 de la figure 2 est une cellule à dix transistors. Elle comprend une cellule de stockage SRAM 12 à six transistors, et deux ports de lecture RPT et RPF à deux transistors chacun. La cellule de stockage 12 comprend deux inverseurs (deux transistors chacun) montés en antiparallèle entre un premier noeud BLTI de stockage d'un bit de donnée, et un deuxième noeud BLFI de stockage d'un bit de donnée complémentaire du bit stocké sur le noeud BLTI. La cellule de stockage 12 comprend en outre un premier transistor d'accès T1, reliant, par ses noeuds de conduction, le noeud BLTI à une piste conductrice WBLT appelée ligne de bit d'écriture, et un deuxième transistor d'accès T2, reliant, par ses noeuds de conduction, le noeud BLFI à une piste conductrice WBLF appelée ligne de bit d'écriture complémentaire. Les grilles des transistors T1 et T2 sont reliées à une même piste conductrice de contrôle d'écriture WWL. Le port de lecture RPT comprend deux transistors T3 et T4 montés en série, via leurs noeuds de conduction, entre une piste conductrice VGNDT d'application d'un potentiel de référence et une piste conductrice de sortie RBLT appelée ligne de bit de lecture. Le transistor T3 est situé côté piste VGNDT et a sa grille reliée au noeud BLTI, et le transistor T4 est situé côté piste RBLT et a sa grille reliée à une piste conductrice de contrôle de lecture RWLT. Le port de lecture RPF comprend deux transistors T5 et T6 montés en série, via leurs noeuds de conduction, entre une piste conductrice VGNDF d'application d'un potentiel de référence et une piste conductrice de sortie RBLF appelée ligne de bit de lecture complémentaire. Le transistor T5 est situé côté piste VGNDF et a sa grille reliée au noeud BLFI, et le transistor T6 est situé côté piste RBLF et a sa grille reliée à une piste conductrice de contrôle de lecture RWLF. Dans cet exemple, les transistors T1, T2, T3, T4, T5, T6 sont des transistors MOS à canal N.

Dans un module mémoire du type décrit en relation avec la figure 1, les cellules élémentaires d'une même rangée du module sont interconnectées via leurs pistes conductrices WWL, respectivement RWLF, respectivement RWLT, et les cellules élémentaires d'une même colonne du module sont interconnectées via leurs pistes conductrices RBLT, respectivement VGNDT, respectivement WBLT, respectivement WBLF, respectivement VGNDF, respectivement RBLF. En d'autres termes, les cellules d'une même rangée partagent une même piste conductrice WWL, une même piste conductrice RWLF, et une même piste conductrice RWLT, et les cellules d'une même colonne partagent une même piste conductrice RBLT, une même piste conductrice VGNDT, une même piste conductrice WBLT, une même piste conductrice WBLF, une même piste conductrice VGNDF, et une même piste conductrice RBLF. Les cellules de rangées distinctes ont quant à elles des pistes conductrices WWL, respectivement RWLF, respectivement RWLT, distinctes, et les cellules de colonnes distinctes ont des pistes conductrices RBLT, respectivement VGNDT, respectivement WBLT, respectivement WBLF, respectivement VGNDF, respectivement RBLF, distinctes. A titre d'exemple, les pistes conductrices WWL, RWLF et RWLT sont connectées au circuit de sélection de rangées RS du module, et les pistes conductrices RBLT, VGNDT, WBLT, WBLF, VGNDF et RBLF sont connectées au circuit d'entrée-sortie IO du module.

A titre d'exemple, la ligne de bit de lecture RBLT de la cellule 10 de la figure 2 correspond à une ligne de bit de lecture RBL du module de la figure 1. Par souci de simplification, dans les figures de module mémoire de la présente demande (les figures 1, 3, 5 et 8), une seule ligne de bit de lecture a été représentée par cellule élémentaire du module. En pratique, les modes de réalisation décrits peuvent être mis en oeuvre soit dans des circuits mémoire constitués de cellules élémentaires à une seule ligne de bit de lecture, par exemple des cellules du type décrit en relation avec la figure 2 mais ne comprenant pas les transistors T5 et T6 et les pistes conductrices VGNDF, RBLF et RWLF, soit dans des circuits mémoire constitués de cellules élémentaires à deux lignes de bit de lecture complémentaires, par exemple du type décrit en relation avec la figure 2, moyennant des adaptations à la portée de l'homme du métier.

Pour réaliser une lecture d'une cellule élémentaire 10 du type décrit en relation avec la figure 2 via son port de lecture RPT, la ligne de bit de lecture RBLT de la cellule est d'abord préchargée à un niveau haut, par exemple à la tension d'alimentation VDD du module. La piste conductrice VGNDT est quant à elle maintenue à un niveau bas, par exemple au potentiel bas GND par rapport auquel est référencée la tension d'alimentation VDD du module. Le transistor T4 de la cellule est ensuite rendu passant par application d'un signal de niveau haut sur la piste conductrice RWLT de la cellule. Après l'activation du transistor T4, la piste conductrice RBLT se décharge si le potentiel du noeud BLTI est à un niveau haut (transistor T3 passant), et reste sensiblement à son niveau de précharge si le potentiel BLTI est à un niveau bas (transistor T3 bloqué). La lecture du potentiel de la piste RBLT via le circuit d'entrée-sortie IO du module permet de déterminer la valeur du bit de donnée stocké dans la cellule élémentaire. La cellule peut en outre être lue sensiblement de la même manière via son port de lecture RPF.

Pour mettre en oeuvre des opérations de calcul, dans un module mémoire constitué de cellules élémentaires 10 du type décrit en relation avec la figure 2, le circuit de contrôle CTRL du module mémoire est adapté à activer simultanément en lecture (via le circuit de sélection de rangées RS) deux, ou un nombre supérieur à deux, de cellules élémentaires d'une même colonne du module, via les ports d'accès RPT, et/ou via les ports d'accès RPF de ces cellules.

A titre d'exemple illustratif, on considère que deux cellules élémentaires 10 d'une même colonne sont activées simultanément en lecture via leurs ports RPT et RPF. Pour cela, après avoir préchargé à un niveau haut les lignes de bit de lecture RBLT et RBLF de la colonne et mis à un niveau bas les pistes conductrices de référence VGNDT et VGNDF de la colonne, les transistors de sélection T4 et T6 des deux cellules sélectionnées sont simultanément rendus passant, via les pistes conductrices de commande RWLT et RWLF des rangées correspondantes. On désigne respectivement par A et B les valeurs binaires mémorisées sur les noeuds BLTI des deux cellules considérées. Les valeurs binaires complémentaires A̅ et B̅ sont alors stockées sur les noeuds BLFI respectifs des deux cellules. La piste conductrice de sortie RBLT de la colonne reste à son niveau haut de précharge uniquement si les deux valeurs A et B sont à un niveau bas. Ainsi, le niveau lu sur la piste de sortie RBLT de la colonne à la fin de l'opération de lecture correspond au résultat A̅+̅B̅ d'une opération de calcul logique NON OU entre les deux cellules mémoire sélectionnées. De plus, la piste conductrice de sortie RBLF de la colonne reste à son niveau haut de précharge uniquement si les deux valeurs A et B sont à un niveau haut. Ainsi, le niveau lu sur la piste de sortie RBLF de la colonne à la fin de l'opération de lecture correspond au résultat A.B d'une opération de calcul logique ET entre les deux cellules mémoire sélectionnées.

En activant simultanément en lecture un nombre supérieur à deux de cellules d'une même colonne, les opérations de calcul susmentionnées peuvent être mises en oeuvre avec un nombre d'opérandes supérieur à 2. De plus, en activant simultanément en lecture plusieurs colonnes du module, ces opérations de calcul peuvent être mises en oeuvre sur des mots de plusieurs bits.

Ainsi, un tel module mémoire permet de mettre en oeuvre des opérations de calcul de base directement dans la mémoire, sans avoir à faire transiter les données par une unité arithmétique et logique externe au circuit.

Pour permettre la réécriture du résultat d'une opération de calcul sans faire transiter la donnée calculée par des circuits externes au module mémoire, et notamment par un bus de données externe au module, le circuit d'entrée-sortie IO du module mémoire peut comprendre un circuit interne de redirection (non détaillé) permettant de relier la ou les lignes de bit de lecture de chaque colonne du module à un noeud d'entrée de donnée de la colonne et/ou d'une autre colonne de la matrice, par exemple à la piste conductrice WBLT et/ou à la piste conductrice WBLF de la colonne ou d'une autre colonne de la matrice dans une architecture du type décrit en relation avec la figure 2.

Dans un module mémoire du type décrit en relation avec les figures 1 et 2, un problème qui se pose est que lorsque le nombre M de rangées de la matrice est important, les temps d'accès aux données stockées dans le module peuvent être relativement élevés. Pour limiter ces temps d'accès, on peut prévoir de partitionner le module en plusieurs matrices de m lignes par N colonnes, où m est un entier inférieur à M, par exemple un sous-multiple de M, chaque matrice de m*N cellules étant associée à son propre circuit d'entrée-sortie et les lignes de bit de lecture des différentes matrices du module n'étant pas connectées entre elles.

Toutefois, un inconvénient est alors que, du fait de l'absence de connexion électrique entre les lignes de bit de lecture des différentes matrices du module, il n'est possible de réaliser des opérations de calcul qu'entre des données contenues dans une même matrice du module.

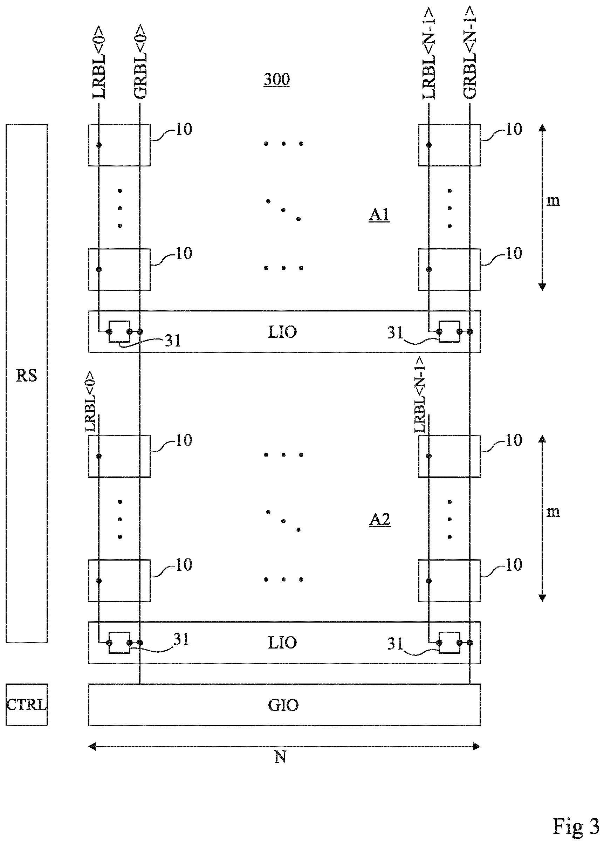

La figure 3 représente de façon schématique un exemple d'un module mémoire 300 selon un mode de réalisation, palliant tout ou partie des inconvénients susmentionnés.

Le module mémoire 300 de la figure 3 comprend une pluralité de cellules élémentaires 10 réparties en deux matrices A1 et A2 de m rangées et N colonnes chacune, où m est un entier, de préférence supérieur ou égal à 2. L'homme du métier saura adapter l'exemple de la figure 3 pour réaliser un module mémoire partitionné en un nombre de matrices supérieur à deux.

Dans chacune des matrices A1 et A2 du module mémoire 300, les cellules élémentaires 10 d'une même colonne de la matrice sont directement connectées (sans circuit de liaison intermédiaire) à une même piste conductrice de sortie ou ligne de bit de lecture locale LRBL de la matrice, étant entendu que les cellules élémentaires 10 de colonnes distinctes sont connectées à des lignes de bit de lecture locales LRBL distinctes. Autrement dit, pour chaque colonne de rang j de la matrice, où j est un entier allant de 0 à N-1, la matrice comprend une ligne de bit de lecture LRBL<j> spécifique à la colonne, connectant entre elles les cellules de la colonne. Les lignes de bit de lecture locales LBRL<j> correspondent aux lignes de bit de lecture RBL<j> du module 100 de la figure 1, c'est-à-dire aux lignes de bit de lecture RBLT des cellules élémentaires 10 de la figure 2.

Pour chacune des matrices A1 et A2, le module 300 comprend un circuit d'entrée-sortie local LIO spécifique à la matrice, par exemple disposé à une extrémité des colonnes de la matrice, auquel sont connectées les lignes de bit de lecture locales LRBL<j> de la matrice. Les lignes de bit de lecture locales LRBL<j> de la matrice A1 ne sont en revanche pas directement connectées aux lignes de bit de lecture locales LRBL<j> de la matrice A2.

Pour chaque rang de colonne j des matrices A1 et A2, le module 300 comprend en outre une piste conductrice GRBL<j> commune aux cellules des colonnes de rang j des matrices A1 et A2, appelée ligne de bit de lecture globale, à laquelle sont reliées les lignes de bit de lecture locales LRBL<j> des matrices A1 et A2. De même que les lignes de bit de lecture locales LRBL<j>, les lignes de bit de lecture globales GRBL<j> s'étendent dans la direction des colonnes des matrices A1 et A2, c'est-à-dire verticalement dans l'orientation de la figure 3.

Pour chacune des matrices A1 et A2 du module, le circuit d'entrée-sortie locale LIO associé à la matrice comprend, pour chaque colonne de la matrice, un circuit de liaison 31 reliant la ligne de bit de lecture locale LRBL<j> de la colonne à la ligne de bit de lecture globale GRBL<j> de cette même colonne. Le circuit de liaison 31 est commandable pour transférer un signal binaire de la ligne de bit de lecture locale LRBL<j> vers la ligne de bit de lecture globale GRBL<j>, ou pour transférer un signal binaire de la ligne de bit de lecture globale GRBL<j> vers la ligne de bit de lecture locale LRBL<j>, ou pour isoler la ligne de bit de lecture locale LRBL<j> de la ligne de bit de lecture globale GRBL<j >.

Les lignes de bit de lecture globales GRBL<j> sont connectées à un même circuit d'entrée-sortie global GIO du module, commun aux matrices A1 et A2 du module.

Le module 300 comprend de plus un circuit de sélection de rangées RS, par exemple disposé à une extrémité des rangées de la matrice.

Le module 300 comprend en outre un circuit de contrôle CTRL adapté à recevoir des instructions provenant d'un dispositif externe au module, et à commander en conséquence les cellules élémentaires 10 du module via le circuit de sélection de rangées RS et/ou via les circuits d'entrée-sortie LIO et GIO du module.

Pour réaliser une lecture d'une cellule élémentaire 10 du module 300, la rangée de la matrice A1 ou A2 contenant la cellule est activée en lecture via le circuit de sélection de rangées RS du module, et la donnée contenue dans la cellule est reportée sur la ligne de bit de lecture locale LRBL<j> connectée à la cellule. Le circuit de contrôle CTRL commande en outre le circuit de liaison 31 correspondant pour transférer la donnée lue sur la ligne de bit de lecture globale GRBL<j> associée à la cellule. La lecture du potentiel de la ligne de bit de lecture globale GRBL<j> via le circuit d'entrée-sortie global GIO permet ainsi de déterminer la valeur du bit de donnée stocké dans la cellule lue.

Pour mettre en oeuvre une opération de calcul ayant pour opérandes deux bits stockés dans deux cellules d'une même colonne de rang j de la matrice A1 ou A2 ou dans une cellule de la colonne de rang j de la matrice A1 et dans une cellule de la colonne de rang j de la matrice A2, le circuit de contrôle CTRL active simultanément en lecture (via le circuit de sélection de rangées RS) les deux rangées correspondantes du module.

Si les rangées sélectionnées appartiennent à la même matrice A1 ou A2 du module, l'opération de calcul est réalisée sur la ligne de bit de lecture locale LRBL<j> de la matrice de façon similaire à ce qui a été décrit ci-dessus en relation avec les figures 1 et 2. Le circuit de contrôle CTRL commande en outre le circuit de liaison 31 correspondant pour transférer le résultat de l'opération sur la ligne de bit de lecture globale GRBL<j> du module. Le résultat de l'opération peut ainsi être lu via le circuit d'entrée-sortie global GIO du module.

Si les rangées sélectionnées appartiennent à des matrices distinctes du module, le circuit de contrôle CTRL commande le circuit de liaison 31 associé à la colonne de rang j de la matrice A1 pour transférer sur la ligne de bit de lecture globale GRBL<j> le signal binaire s'établissant sur la ligne de bit de lecture locale LRBL<j> de la matrice A1, et le circuit de liaison 31 associé à la colonne de rang j de la matrice A2 pour transférer sur la ligne de bit de lecture globale GRBL<j> le signal binaire s'établissant sur la ligne de bit de lecture locale LRBL<j> de la matrice A2. L'opération de calcul proprement dite, c'est-à-dire la combinaison des états logiques présents sur les lignes de bit de lecture locales LRBL<j> des matrices A1 et A2, est alors réalisé directement sur la ligne de bit de lecture globale GRBL<j>. Le résultat de l'opération peut être lu via le circuit d'entrée-sortie global GIO du module.

Ainsi, le module mémoire 300 de la figure 3 présente l'avantage d'être partitionné en plusieurs matrices, ce qui procure un gain en vitesse d'accès aux données stockées dans la mémoire associé à une réduction significative de la consommation dynamique, et permet de réaliser des opérations de calcul ayant pour opérandes des données stockées dans différentes matrices du module.

On notera que pour certaines opérations, notamment pour transférer des données de la matrice A1 vers la matrice A2, le circuit de contrôle peut commander le circuit de liaison 31 associé à la colonne de rang j de la matrice A1 pour transférer sur la ligne de bit de lecture locale LRBL<j> de la matrice A1 le signal binaire s'établissant sur la ligne de bit de lecture locale GRBL<j>.

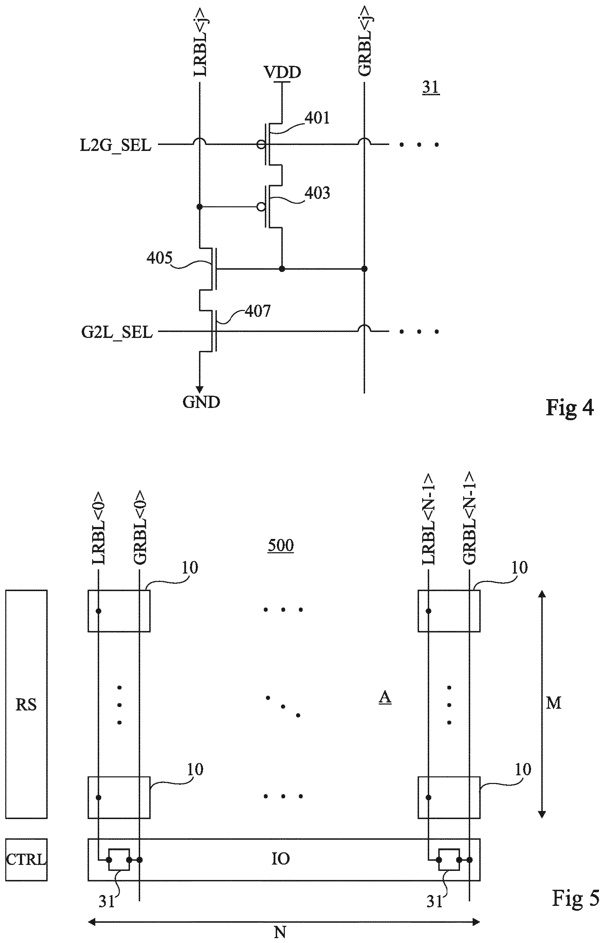

La figure 4 est un schéma électrique d'un exemple de réalisation d'un circuit de liaison 31 du module mémoire 300 de la figure 3.

Le circuit de liaison 31 de la figure 4 comprend deux transistors 401 et 403 connectés en série, par leurs noeuds de conduction (source et drain), entre un noeud VDD d'application de la tension d'alimentation du module et la ligne de bit de lecture globale GRBL<j> à laquelle le circuit de liaison 31 est associé. Plus particulièrement le transistor 401 a un premier noeud de conduction connecté au noeud VDD et un deuxième noeud de conduction connecté à un premier noeud de conduction du transistor 403, et le transistor 403 a un deuxième noeud de conduction connecté à la piste GRBL<j>.

Le circuit de liaison 31 de la figure 4 comprend de plus deux transistors 405 et 407 connectés en série, par leurs noeuds de conduction, entre la ligne de bit de lecture locale LRBL<j> à laquelle le circuit de liaison 31 est associé et un noeud GND d'application d'un potentiel de référence du module, par exemple la masse. Plus particulièrement, le transistor 405 a un premier noeud de conduction connecté à la piste LRBL<j> et un deuxième noeud de conduction connecté à un premier noeud de conduction du transistor 407, et le transistor 407 a un deuxième noeud de conduction connecté au noeud GND.

La grille du transistor 403 est connectée au premier noeud de conduction du transistor 405, c'est-à-dire à la piste LRBL<j>, et la grille du transistor 405 est connectée au deuxième noeud de conduction du transistor 403, c'est-à-dire à la piste GRBL<j>.

Dans cet exemple, les transistors 401 et 403 sont des transistors MOS à canal P et les transistors 405 et 407 sont des transistors MOS à canal N.

La grille du transistor 401 est connectée à une piste conductrice de commande L2G_SEL, et la grille du transistor 407 est connectée à une piste conductrice de commande G2L_SEL. Les circuits de liaison 31 associés à une même matrice du module mémoire sont par exemple interconnectés via leurs pistes conductrices L2G_SEL d'une part et via leurs pistes conductrices G2L_SEL d'autre part.

Le circuit de liaison 31 peut être commandé par le circuit de contrôle CTRL du module :
- dans une première configuration dans laquelle le transistor 401 est rendu passant par application d'un signal adapté sur la piste L2G_SEL et le transistor 407 est maintenu bloqué par application d'un signal de commande adapté sur la piste G2L_SEL,
- dans une deuxième configuration dans laquelle le transistor 401 est maintenu bloqué par application d'un signal adapté sur la piste L2G_SEL et le transistor 407 est rendu passant par application d'un signal adapté sur la piste G2L_SEL, ou
- dans une troisième configuration dans laquelle les transistors 401 et 407 sont tous les deux maintenus bloqués.

Lors d'une opération de lecture d'une cellule élémentaire du module 300, la ligne de bit de lecture locale LRBL<j> de la colonne contenant la cellule est d'abord préchargée à un niveau haut, par exemple à la tension d'alimentation VDD du module, et la ligne de bit de lecture globale GRBL<j> de la colonne contenant la cellule est préchargée à un niveau bas, par exemple au potentiel de référence GND du module. La rangée de la matrice A1 ou A2 contenant la cellule est alors activée en lecture, de sorte que la ligne de bit de lecture locale LRBL<j> se décharge lorsque la donnée stockée dans la cellule a une première valeur binaire, par exemple la valeur binaire '1', et reste chargée lorsque la donnée stockée dans la cellule à la valeur binaire opposée, par exemple la valeur binaire '0'. La décharge de la ligne de bit de lecture locale LRBL<j> conduit à rendre passant le transistor 403, ce qui provoque la charge de la ligne de bit de lecture globale GRBL<j> de la colonne au potentiel VDD. Si au contraire la ligne de bit de lecture locale LRBL<j> reste chargée, le transistor 403 est maintenu bloqué et la ligne de bit de lecture globale GRBL<j> reste sensiblement au potentiel GND. Ainsi, le signal binaire porté par la ligne de bit de lecture locale LRBL<j> est bien transmis (inversé dans cet exemple) sur la ligne de bit de lecture globale GRBL<j>, et peut ainsi être lu par le circuit d'entrée-sortie global GIO du module.

Lors d'une opération de calcul ayant pour opérandes deux bits stockés dans deux cellules d'une même colonne de rang j de la matrice A1 ou A2 du module, la ligne de bit de lecture locale LRBL<j> de la matrice contenant les cellules est d'abord préchargée à un niveau haut, et la ligne de bit de lecture globale GRBL<j> est préchargée à un niveau bas. Les rangées de la matrice A1 ou A2 contenant les cellules sont alors activée en lecture simultanément, de sorte que le potentiel de la ligne de bit de lecture locale LRBL<j> prend un état haut ou bas fonction du résultat de l'opération logique réalisée entre les deux cellules. Si la ligne de bit de lecture locale LRBL<j> se décharge, le transistor 403 devient conducteur, ce qui provoque la charge de la ligne de bit de lecture globale GRBL<j> de la colonne au potentiel VDD. Si au contraire la ligne de bit de lecture locale LRBL<j> reste chargée, le transistor 403 est maintenu bloqué et la ligne de bit de lecture globale GRBL<j> reste sensiblement au potentiel GND. Ainsi, le signal binaire porté par la ligne de bit de lecture locale LRBL<j>, correspondant au résultat de l'opération logique réalisée entre les deux cellules activées, est bien transmis (inversé dans cet exemple) sur la ligne de bit de lecture globale GRBL<j>, et peut ainsi être lu par le circuit d'entrée-sortie global GIO du module.

Lors d'une opération de calcul ayant pour opérandes deux bits stockés respectivement dans une cellule d'une colonne de rang de rang j de la matrice A1 et dans une cellule d'une colonne de même rang j de la matrice A2, la ligne de bit de lecture locale LRBL<j> de la matrice A1 et la ligne de bit de lecture locale LRBL<j> de la matrice A2 sont d'abord préchargées à un niveau haut, et la ligne de bit de lecture globale GRBL<j> est préchargée à un niveau bas. Les rangées des matrices A1 et A2 contenant les cellules sont ensuite activées en lecture simultanément. Dans chacune des matrice A1 et A2, la ligne de bit de lecture locale LRBL<j> se décharge ou reste chargée en fonction de la valeur stockée dans la cellule sélectionnée. Si au moins l'une des deux lignes de bit de lecture locales LRBL<j> se décharge, le transistor 403 du circuit de liaison 31 correspondant devient passant, et la ligne de bit de lecture globale GRBL<j> se charge au potentiel VDD. Si les deux lignes de bit de lecture locales LRBL<j> restent chargées, les transistors 403 des circuits de liaison 31 correspondants restent bloqués, et la ligne de bit de lecture globale GRBL<j> reste sensiblement au potentiel GND. Ainsi, le signal binaire porté par la ligne de bit de lecture globale GRBL<j>, correspond bien au résultat d'une opération logique réalisée entre les deux cellules activées. Ce signal peut être lu par le circuit d'entrée-sortie global GIO du module.

Pour permettre la réécriture du résultat d'une opération de calcul ou de lecture sans faire transiter la donnée calculée ou lue par des circuits externes au module mémoire, et notamment par un bus de données externe au module, chaque circuit d'entrée-sortie local LIO du module mémoire peut comprendre un circuit interne de redirection (non détaillé) permettant de relier la ou les lignes de bit de lecture locales de chaque colonne de la matrice correspondante à une ligne de bit d'écriture de donnée de la colonne et/ou d'une autre colonne de la matrice, par exemple à la piste conductrice WBLT et/ou à la piste conductrice WBLF de la colonne ou d'une autre colonne de la matrice.

On a décrit en relation avec les figures 3 et 4 un exemple de réalisation d'un module mémoire partitionné en plusieurs matrices, ce module étant adapté à mettre en oeuvre des opérations de calcul ayant pour opérandes des données stockées dans des matrices distinctes du module. Toutefois, dans certaines applications, un circuit mémoire peut comprendre plusieurs modules mémoire, par exemple identiques ou similaires, par exemple des modules du type décrit en relation avec la figure 1 ou des modules du type décrit en relation avec la figure 3. Là encore, ceci permet de réaliser un partitionnement de la mémoire et ainsi de limiter les temps d'accès aux cellules élémentaires du circuit mémoire tout en minimisant la consommation dynamique. Toutefois, un inconvénient est qu'il n'est alors possible de réaliser des opérations de calcul qu'entre des données contenues dans un même module. On va maintenant décrire en relation avec les figures 5, 6 et 7, un exemple de réalisation d'un circuit mémoire comprenant plusieurs modules mémoire, ce circuit permettant la mise en oeuvre d'opérations de calcul ayant pour opérandes des données stockées dans différents modules du circuit mémoire.

La figure 5 représente de façon schématique un exemple d'un module mémoire 500 selon un mode de réalisation.

Comme dans l'exemple de la figure 1, le module mémoire 500 comprend une pluralité de cellules élémentaires 10 agencée selon une matrice A de M rangées et N colonnes. De plus, comme dans les exemples précédents, les cellules élémentaires 10 d'une même colonne de la matrice A sont directement connectées à une même piste conductrice de sortie ou ligne de bit de lecture locale LRBL de la matrice, étant entendu que les cellules élémentaires 10 de colonnes distinctes sont connectées à des lignes de bit de lecture locales LRBL distinctes. Autrement dit, pour chaque colonne de rang j de la matrice, où j est un entier allant de 0 à N-1, la matrice A comprend une ligne de bit de lecture LRBL<j> spécifique à la colonne, connectant entre elles les cellules de la colonne. Les lignes de bit de lecture locales LBRL<j> correspondent aux lignes de bit de lecture RBL<j> du module 100 de la figure 1, c'est-à-dire aux lignes de bit de lecture RBLT des cellules élémentaires 10 de la figure 2.

Le module 500 comprend en outre un circuit d'entrée-sortie IO, par exemple disposé à une extrémité des colonnes de la matrice, auquel sont connectées les lignes de bit de lecture locales LRBL<j> de la matrice.

Pour chaque colonne de rang j de la matrice A, le module 500 comprend en outre une piste conductrice GRBL<j> appelée ligne de bit de lecture globale, à laquelle est reliée la ligne de bit de lecture locale LRBL<j> de la colonne par l'intermédiaire d'un circuit de liaison 31.

Plus particulièrement, pour chaque colonne de la matrice A, le circuit d'entrée-sortie IO du module comprend un circuit de liaison 31, par exemple identique au circuit de liaison 31 décrit ci-dessus en relation avec les figures 3 et 4, reliant la ligne de bit de lecture locale LRBL<j> de la colonne à la ligne de bit de lecture globale GRBL<j> de cette même colonne.

Le module 500 comprend de plus un circuit de sélection de rangées RS, par exemple disposé à une extrémité des rangées de la matrice.

Le module 500 comprend en outre un circuit de contrôle CTRL adapté à recevoir des instructions provenant d'un dispositif externe au module, et à commander en conséquence les cellules élémentaires 10 du module via le circuit de sélection de rangées RS et/ou via le circuit d'entrée-sortie IO du module.

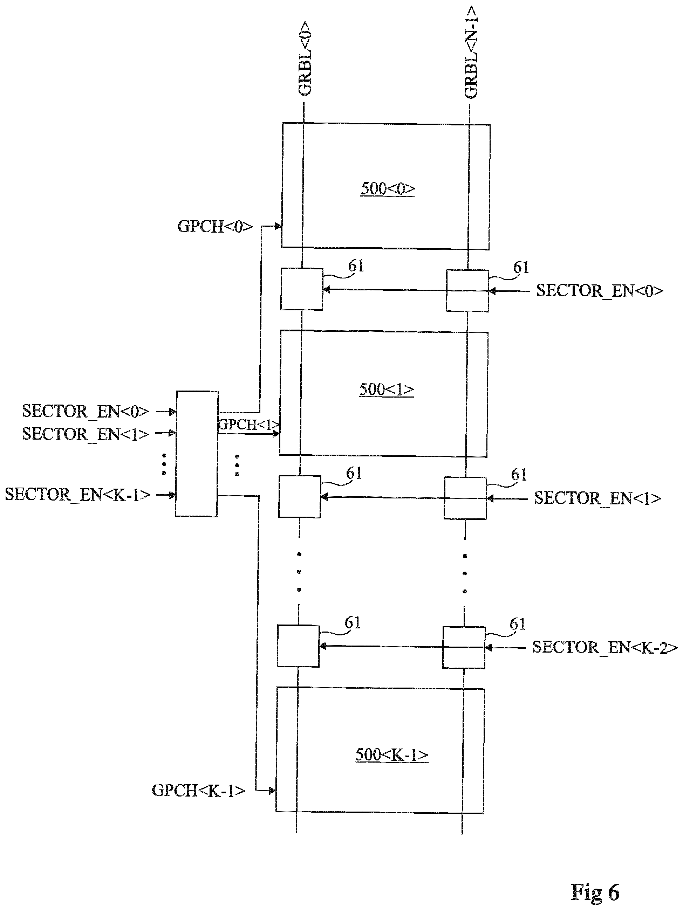

La figure 6 représente de façon schématique un exemple d'un circuit mémoire comprenant plusieurs modules mémoire du type décrit en relation avec la figure 5. Plus particulièrement, dans l'exemple représenté, le circuit mémoire comprend K modules mémoire 500<l>, avec K entier supérieur ou égal à 2 et l entier allant de 0 à K-1. Par souci de simplification, seules les lignes de bit de lecture globales GRBL<j> des différents modules ont été détaillées sur la figure 6.

Pour chaque rang de colonne j, les lignes de bit de lecture globales GRBL<j> des différents modules mémoire 500 sont reliées en série par l'intermédiaire de circuits de liaison 61. Plus particulièrement, pour chaque rang de colonne j, pour chaque module mémoire 500<l> à l'exception des modules 500<0> et 500<K-1>, la ligne de bit de lecture globale GRBL<j> du module 500<l> a une première extrémité reliée à une extrémité de la ligne de bit de lecture globale GRBL<j> du module 500<l-1> par un premier circuit de liaison 61 et une deuxième extrémité reliée à une extrémité de la ligne de bit de lecture globale GRBL<j> du module 500<l+1> par un deuxième circuit de liaison 61. Ainsi, dans cet exemple, le circuit mémoire comprend (K-1)*N circuits de liaison 61, par exemple identiques ou similaires, reliant en chaine ouverte les modules mémoire 500<0> à 500<K-1>. L'extrémité libre du module 500<0> et l'extrémité libre du module 500<K-1> peuvent quant à elles être reliées à des circuits périphériques d'entrée/sortie du circuit mémoire.

Pour chaque rang de colonne j, et pour chaque module mémoire 500<l> à l'exception du module 500<K-1>, le circuit de liaison 61 reliant la ligne de bit de lecture globale GRBL<j> du module 500<l> à la ligne de bit de lecture globale GRBL<j> du module 500<l+1> est commandable soit pour isoler la ligne de bit GRBL<j> du module 500<l> de la ligne de bit GRBL<j> du module 500<l+1>, soit pour recopier (éventuellement en l'amplifiant et/ou en le redressant et/ou en le bufferisant - c'est-à-dire en le stockant temporairement) sur la ligne de bit GRBL<j> du module 500<l+1> un signal binaire présent sur la ligne de bit GRBL<j> du module 500<l>, soit pour recopier (éventuellement en l'amplifiant) sur la ligne de bit GRBL<j> du module 500<l> un signal binaire présent sur la ligne de bit GRBL<j> du module 500<l+1>.

Dans l'exemple de la figure 6, pour chaque module mémoire 500<l> à l'exception du module 500<K-1>, les N circuits de liaison 61 reliant le module 500<l> au module 500<l+1> sont commandables simultanément via un même signal de commande SECTOR_EN<1>.

Le circuit mémoire de la figure 6 peut comprendre un circuit de contrôle global (non représenté) adapté à commander les modules 500<l> et les circuits de liaison 61.

Pour réaliser une lecture d'une cellule élémentaire 10 du circuit mémoire de la figure 6, la rangée de la matrice A du module 500<l> contenant la cellule est activée en lecture via le circuit de sélection de rangées RS du module, et la donnée contenue dans la cellule est reportée sur la ligne de bit de lecture locale LRBL<j> connectée à la cellule. La donnée est alors lue par le circuit d'entrée-sortie IO du module 500<l>. Lors de cette opération, le circuit de liaison 31 connecté à la ligne de bit de lecture locale LBRL<j> du module 500<l> peut être commandé pour isoler la ligne de bit de lecture locale LRBL<j> du module 500<l> de la ligne de bit de lecture globale GRBL<j> du module 500<l>, et les circuits de liaison 61 du circuit mémoire peuvent être commandés pour isoler les unes des autres les lignes de lecture globales GRBL<j> des différents modules. A titre de variante, le circuit de contrôle CTRL du module commande le circuit de liaison 31 reliant la ligne de bit de lecture locale LRBL<j> du module à la ligne de bit de lecture globale GRBL<j> du module pour transférer sur la ligne GRBL<j> du module le signal présent sur la ligne LRBL<j> du module (avec inversion du signal dans le cas du circuit de liaison 31 de la figure 4). Le ou les circuits de liaison 61 reliant la ligne de bit de lecture globale GRBL<j> du module 500<l> aux circuits périphériques d'entrée/sortie du circuit mémoire, c'est-à-dire à l'extrémité libre de la ligne de bit de lecture globale GRBL<0> du module 500<0> ou à l'extrémité libre de la ligne de bit de lecture globale GRBL<K-1> du module 500<K-1> dans cet exemple, sont en outre commandés pour transférer vers les circuits périphériques d'entrée/sortie le signal binaire présent sur la ligne de bit de lecture globale GRBL<j> du module 500<l>. La donnée peut alors être lue par les circuits périphériques d'entrée/sortie du circuit mémoire.

Pour réaliser une opération de calcul ayant pour opérandes deux bits stockés dans deux cellules d'une même colonne de rang j d'un module 500<l> du circuit mémoire de la figure 6, le circuit de contrôle CTRL du module 500<l> active simultanément en lecture les rangées correspondantes du module. L'opération de calcul est alors réalisée sur la ligne de bit de lecture locale LRBL<j> du module de façon similaire à ce qui a été décrit ci-dessus, et le résultat de l'opération peut être lu par le circuit d'entrée-sortie IO du module. Lors de cette opération, le circuit de liaison 31 connecté à la ligne de bit de lecture locale LBRL<j> du module 500<l> peut être commandé pour isoler la ligne de bit de lecture locale LRBL<j> du module 500<l> de la ligne de bit de lecture globale GRBL<j> du module 500<l>, et les circuits de liaison 61 du circuit mémoire peuvent être commandés pour isoler les unes des autres les lignes de bit de lecture globales GRBL<j> des différents modules. A titre de variante, le circuit de contrôle CTRL du module commande le circuit de liaison 31 reliant la ligne de bit de lecture locale LRBL<j> du module à la ligne de bit de lecture globale GRBL<j> du module pour transférer sur la ligne GRBL<j> du module le signal présent sur la ligne LRBL<j> du module (avec inversion du signal dans le cas du circuit de liaison 31 de la figure 4). Le ou les circuits de liaison 61 reliant la ligne de bit de lecture globale GRBL<j> du module 500<l> aux circuits périphériques d'entrée/sortie du circuit mémoire, c'est-à-dire à l'extrémité libre de la ligne de bit de lecture globale GRBL<0> du module 500<0> ou à l'extrémité libre de la ligne de bit de lecture globale GRBL<K-1> du module 500<K-1> dans cet exemple, sont en outre commandés pour transférer vers les circuits périphériques d'entrée/sortie le signal binaire présent sur la ligne de bit de lecture globale GRBL<j> du module 500<l>. Le résultat de l'opération peut alors être lu par les circuits périphériques d'entrée/sortie du circuit mémoire.

Pour réaliser une opération de calcul ayant pour opérandes deux bits stockés dans deux cellules appartenant respectivement à une colonne de rang j d'un module 500<l> et à une colonne de même rang j d'un module 500<l'>, avec l' entier allant de 0 à K-1 et l' différent de l, les circuits de contrôle CTRL des modules 500<l> et 500<l'> activent simultanément en lecture les rangées correspondantes des modules 500<l> et 500<l'>. De plus, dans l'un des deux modules, par exemple le module 500<l>, le circuit de contrôle CTRL du module commande le circuit de liaison 31 reliant la ligne de bit de lecture locale LRBL<j> du module à la ligne de bit de lecture globale GRBL<j> du module pour transférer sur la ligne GRBL<j> du module le signal présent sur la ligne LRBL<j> du module (avec inversion du signal dans le cas du circuit de liaison 31 de la figure 4). Le ou les circuits de liaison 61 reliant la ligne de bit de lecture globale GRBL<j> du module 500<l> à la ligne de bit de lecture globale GRBL<j> du module 500<l'> sont en outre commandés pour recopier sur la ligne de bit de lecture globale GRBL<j> du module 500<l'> le signal binaire présent sur la ligne de bit de lecture globale GRBL<j> du module 500<l>. En outre, dans le module 500<l'>, le circuit de contrôle CTRL du module commande le circuit de liaison 31 reliant la ligne de bit de lecture globale GRBL<j> du module à la ligne de bit de lecture locale LRBL<j> du module pour transférer sur la ligne de bit LRBL<j> du module le signal binaire présent sur la ligne de bit GRBL<j> du module (avec inversion du signal dans le cas du circuit de liaison 31 de la figure 4). L'opération de calcul est alors réalisée sur la ligne de bit de lecture locale LRBL<j> du module 500<l'>, et le résultat de l'opération peut être lu par le circuit d'entrée-sortie IO du module 500<l'>. Lors de cette opération, les circuits de liaison 61 connectés aux lignes de bit de lecture globales GRBL<j> des modules 500 ne se trouvant pas sur le chemin de l'opération (c'est-à-dire ne se trouvant pas entre les modules 500<l> et 500<l'>), peuvent être commandés à l'état bloqué (c'est-à-dire isolant électriquement les unes des autres les lignes de bit GRBL<j> qu'ils relient). A titre de variante, l'opération de calcul proprement dite est réalisée sur une ligne de bit de lecture globale, par exemple la ligne de bit de lecture globale GRBL<j> du module 500<l'>. Pour cela, dans chacun des modules 500<l> et 500<l'>, le circuit de liaison 31 du module est commandé pour transférer sur la ligne de bit globale GRBL<j> du module le signal présent sur sa ligne de bit locale LRBL<j>, et le ou les circuits de liaison séparant la ligne de bit globale GRBL<j> du module 500<l> de la ligne de bit globale GRBL<j> du module 500<l'> sont commandés pour transférer sur la ligne de bit globale GRBL<j> du module 500<l'> le signal présent sur la ligne de bit globale GRBL<j> du module 500<l>. Le ou les circuits de liaison 61 reliant la ligne de bit de lecture globale GRBL<j> du module 500<l'> aux circuits périphériques d'entrée/sortie du circuit mémoire sont en outre commandés pour transférer vers les circuits périphériques d'entrée/sortie le signal binaire présent sur la ligne de bit de lecture globale GRBL<j> du module 500<l'>. Le résultat de l'opération peut alors être lu par les circuits périphériques d'entrée/sortie du circuit mémoire. On notera en outre que dans les modules mémoire 500 non concernés par l'opération, c'est-à-dire dont les lignes de bit de lecture globales GRBL<j> ne sont pas utilisées pour transmettre une donnée opérande ou une donnée résultat, les lignes de bit de lecture globales GRBL<j> peuvent être maintenues à leur potentiel de précharge pendant toute la durée de l'opération. Ceci permet d'éviter d'avoir à les précharger à nouveau lors de l'opération suivante, et ainsi d'augmenter la vitesse de fonctionnement du circuit mémoire, ainsi que de minimiser la consommation dynamique. Dans l'exemple de la figure 6, le circuit mémoire comprend pour cela un circuit logique 601 recevant les signaux de commande SECTOR_EN<0>, ... SECTOR_EN<K-2> des circuits de liaison 61, et fournissant à chaque module 500<l> un signal de commande de précharge GPCH<l>. Lorsque le module 500<l> ne se situe pas sur le chemin de l'opération, le signal GPCH<l> fourni par le circuit 601 est à un premier état tel que le circuit de contrôle CTRL du module 500<l> commande le maintien de la précharge des lignes de bit de lecture globales GRBL<j> du module pendant toute la durée de l'opération. Lorsque le module 500<l> se situe sur le chemin de l'opération, le signal GPCH<l> fourni par le circuit 601 est à un deuxième état tel que le circuit de contrôle CTRL du module 500<l> commande l'interruption de l'application du potentiel de précharge des lignes de bit de lecture globales GRBL<j> du module, de façon à les laisser flottantes et à permettre la mise en oeuvre de l'opération.

On notera que bien que l'on ait représenté sur la figure 6 un exemple de réalisation dans lequel les modules mémoire 500 sont reliés deux à deux en série par l'intermédiaire de circuits de liaison 61, les modes de réalisation décrits ne se limitent pas à ce cas particulier. A titre de variante, les modules mémoire 500 peuvent être répartis en plusieurs groupes de plusieurs modules 500 par groupe, les modules d'un même groupe étant directement connectés en série via leurs lignes de bit de lecture globales GRBL<j>, et les groupes de modules étant reliés en série par l'intermédiaire de circuits de liaison 61.

Pour permettre la réécriture du résultat d'une opération de calcul ou de lecture sans faire transiter la donnée calculée ou lue par des circuits externes au circuit mémoire, et notamment par un bus de données externe au circuit mémoire, chaque circuit d'entrée-sortie local IO (figure 5) du circuit mémoire peut comprendre un circuit interne de redirection (non détaillé) permettant de relier la ou les lignes de bit de lecture locales de chaque colonne de la matrice correspondante à une ligne de bit d'écriture de donnée de la colonne et/ou d'une autre colonne de la matrice, par exemple à la piste conductrice WBLT et/ou à la piste conductrice WBLF de la colonne ou d'une autre colonne de la matrice.

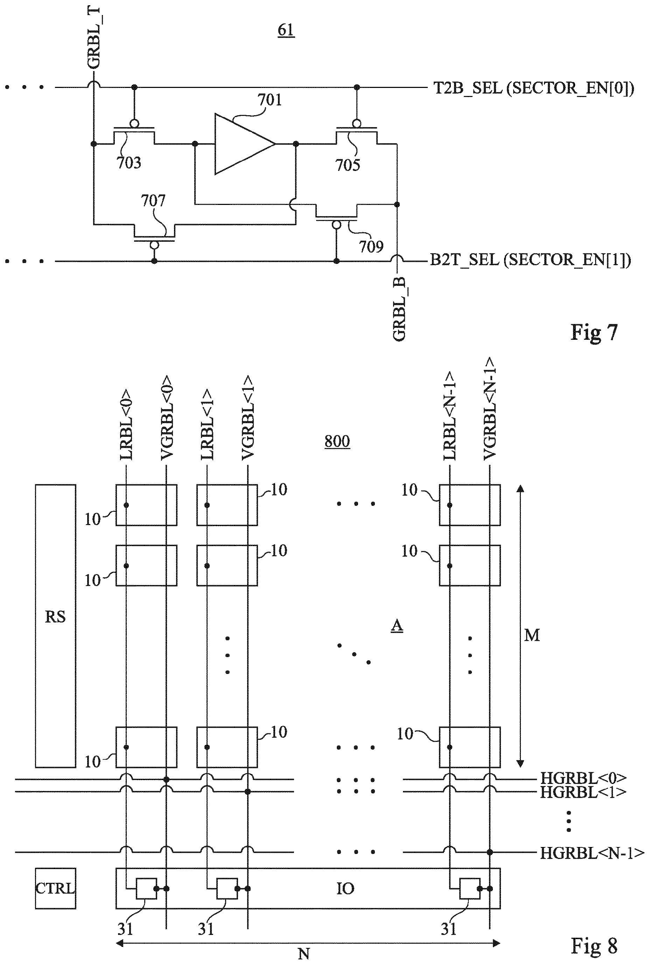

La figure 7 est un schéma électrique d'un exemple de réalisation d'un circuit de liaison 61 du circuit mémoire de la figure 6, reliant une ligne de bit de lecture globale GRBL<j> d'un module 500 du circuit mémoire, référencée GRBL_T sur la figure 7, à une ligne de bit de lecture globale GRBL<j> de même rang j d'un module 500 voisin, référencée GRBL_B sur la figure 7.

Le circuit de liaison 61 comprend un amplificateur (ou un buffer ou inverseur) 701 ayant une entrée reliée à la piste conductrice GRBL_T par un transistor 703 et une sortie reliée à la piste conductrice GRBL_B par un transistor 705. Le circuit 61 de la figure 7 comprend en outre un transistor 707 reliant la piste conductrice GRBL_T à la sortie de l'amplificateur 701, et un transistor 709 reliant la piste conductrice GRBL_B à l'entrée de l'amplificateur 701. Dans cet exemple, les transistors 703, 705, 707 et 709 sont des transistors MOS à canal P. Les grilles des transistors 703 et 705 sont connectées à une même première piste conductrice de commande T2B SEL du circuit 61, et les grilles des transistors 707 et 709 sont connectées à une même deuxième piste conductrice de commande B2T_SEL du circuit 61.

Dans cet exemple, le signal SECTOR EN de commande du circuit de liaison 61 est un signal sur deux bits, désignés respectivement par les références SECTOR_EN[0] et SECTOR_EN[1], appliqués respectivement les pistes conductrices T2B_SEL et B2T_SEL du circuit.

Dans une première configuration (signaux SECTOR_EN[0] et SECTOR_EN[1] respectivement à l'état bas et à l'état haut dans cet exemple), les transistors 703 et 705 sont passants et les transistors 707 et 709 sont bloqués, de sorte que le circuit 61 recopie sur la ligne de bit GRBL_B le signal binaire présent sur la ligne de bit GRBL_T.

Dans une deuxième configuration (signaux SECTOR_EN[0] et SECTOR_EN[1] respectivement à l'état haut et à l'état bas dans cet exemple), les transistors 707 et 709 sont passants et les transistors 703 et 705 sont bloqués, de sorte que le circuit 61 recopie sur la ligne de bit GRBL_T le signal binaire présent sur la ligne de bit GRBL_B.

Dans une troisième configuration (signaux SECTOR_EN[0] et SECTOR_EN[1] à l'état haut dans cet exemple), les transistors 703, 705, 707 et 709 sont bloqués, de sorte que le circuit 61 isole la ligne de bit GRBL_B de la ligne de bit GRBL_T.

On notera que dans cet exemple, la quatrième configuration (signaux SECTOR_EN[0] et SECTOR_EN[1] à l'état bas) n'est jamais utilisée (configuration interdite).

La figure 8 représente de façon schématique un autre exemple d'un module mémoire 800 selon un mode de réalisation.

Le module mémoire 800 de la figure 8 comprend les mêmes éléments que le module mémoire 500 de la figure 5 agencés sensiblement de la même manière. On notera toutefois que les lignes de bit de lecture globales GRBL<0> à GRBL<N-1> du module mémoire 500 de la figure 5 sont référencées respectivement VGRBL<0> à VGRBL<N-1> sur la figure 8.

Comme indiqué précédemment, les lignes de bit de lecture locales LRBL<j> et les lignes de bit de lecture globales VGRBL<j> s'étendent selon la direction des colonnes de la matrice A, c'est-à-dire verticalement dans l'orientation de la figure 8. Ceci permet de réaliser un circuit mémoire comprenant plusieurs modules mémoire agencés en barrette comme cela a été décrit en relation avec la figure 6.

Dans l'exemple de la figure 8, le module 800 comprend en outre, pour chaque colonne de rang j de la matrice A, une deuxième ligne de bit de lecture globale HGRBL<j> commune aux cellules de la colonne, disposée selon une orientation parallèle aux rangées de la matrice, c'est-à-dire horizontalement dans l'orientation de la figure 8. Pour chaque colonne de rang j, la ligne de bit de lecture globale horizontale HGRBL<j> associée à la colonne est directement connectée à la ligne de bit de lecture globale verticale VGRHB<j> associée à cette même colonne.

Dans l'exemple représenté, les lignes de bit de lecture globales horizontales HGRBL<0> à HGRBL<N-1> sont disposées du côté d'une extrémité des colonnes de la matrice A, c'est-à-dire qu'elles ne s'étendent pas au-dessus de la matrice A. A titre de variante (non représentée), les lignes de bit de lecture globales horizontales HGRBL<0> à HGRBL<N-1> peuvent être disposées au-dessus de la matrice A.

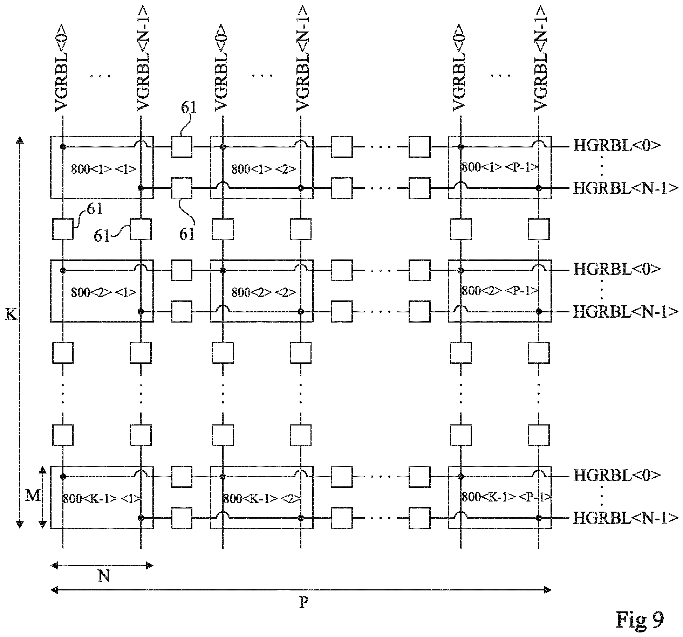

Un avantage résultant de la prévision des lignes de bit de lecture globales horizontales HGRBL<0> à HGRBL<N-1> est que ceci permet de réaliser un circuit mémoire comprenant plusieurs modules mémoire agencés en matrice selon des rangées et des colonnes comme représenté en figure 9.

La figure 9 représente de façon schématique un exemple d'un circuit mémoire comprenant plusieurs modules mémoire du type décrit en relation avec la figure 8. Plus particulièrement, dans l'exemple représenté, le circuit mémoire K*P modules mémoire 800<l><q>, agencés en matrice selon K rangées et P colonnes, avec K et P entiers supérieurs ou égaux à 2, l entier allant de 0 à K-1 désignant le rang de la rangée à laquelle appartient le module, et q entier allant de 0 à P-1 désignant le rang de la colonne à laquelle appartient le module.

Par souci de simplification, seules les lignes de bit de lecture globales verticales VGRBL<j> et horizontales HGRBL<j> des différents modules ont été détaillées sur la figure 9.

Dans chaque colonne de rang q du circuit mémoire, pour chaque rang de colonne j des modules mémoire 800 de la colonne, les lignes de bit de lecture globales verticales VGRBL<j> des différents modules mémoire 800 de la colonne sont reliées en série par l'intermédiaire de circuits de liaison 61 de façon similaire à ce qui a été décrit en relation avec la figure 6. Plus particulièrement, dans chaque colonne de rang q du circuit mémoire, pour chaque rang de colonne j des modules mémoire 800 de la colonne, pour chaque module mémoire 800<l><q> à l'exception des modules 500<0><q> et 500<K-1><q>, la ligne de bit de lecture globale verticale VGRBL<j> du module 800<l><q> a une première extrémité reliée à une extrémité de la ligne de bit de lecture globale VGRBL<j> du module 800<l-1><q> par un premier circuit de liaison 61 et une deuxième extrémité reliée à une extrémité de la ligne de bit de lecture globale VGRBL<j> du module 800<l+1><q> par un deuxième circuit de liaison 61.

De plus, dans chaque rangée de rang l du circuit mémoire, pour chaque rang de colonne j des modules mémoire 800 de la colonne, les lignes de bit de lecture globales horizontales HGRBL<j> des différents modules mémoire 800 de la rangée sont reliées en série par l'intermédiaire de circuits de liaison 61. Plus particulièrement, dans chaque rangée de rang l du circuit mémoire, pour chaque rang de colonne j des modules mémoire 800 de la rangée, pour chaque module mémoire 800<l><q> à l'exception des modules 500<l><0> et 500<l><P-1>, la ligne de bit de lecture globale horizontale HGRBL<j> du module 800<l><q> a une première extrémité reliée à une extrémité de la ligne de bit de lecture globale HGRBL<j> du module 800<l><q-1> par un premier circuit de liaison 61 et une deuxième extrémité reliée à une extrémité de la ligne de bit de lecture globale HGRBL<j> du module 800<l><q+1> par un deuxième circuit de liaison 61.

Ainsi, dans cet exemple, le circuit mémoire comprend ((K-1)*N*P) + ((P-1)*N*K) circuits de liaison 61, par exemple identiques ou similaires, par exemple des circuits de liaison du type décrit en relation avec la figure 7.

Une commande appropriée des circuits de liaison 61 permet la mise en oeuvre d'opérations de calcul ayant pour opérandes des données stockées dans différents modules du dispositif, quelles que soient les positions desdits modules dans le circuit.

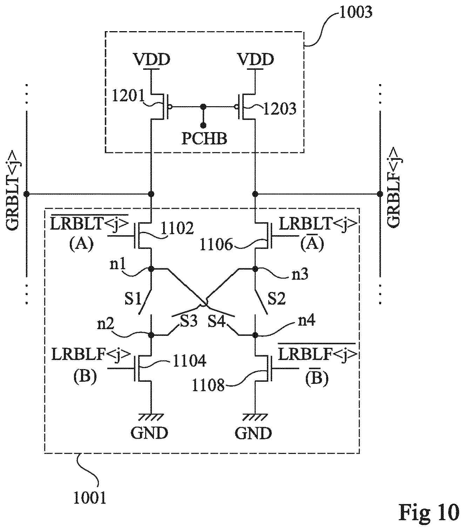

La figure 10 illustre une variante d'un module mémoire selon un mode de réalisation.

On considère dans cet exemple un module mémoire du type décrit en relation avec la figure 3 ou 5. On considère plus particulièrement dans cet exemple un module mémoire dont les cellules élémentaires 10 sont des cellules à deux lignes de bit de lecture LRBLT et LRBLF, par exemple du type décrit en relation avec la figure 2. Pour chaque rang de colonne j de la ou des matrices du module, le module comprend deux lignes de bit de lecture globales GRBLT<j> et GRBLF<j>. Chaque ligne de bit de lecture locale LRBLT<j> est reliée à la ligne de bit de lecture globale GRBLT<j> correspondante par un circuit de liaison 31, par exemple du type décrit en relation avec la figure 4. De plus, chaque ligne de bit de lecture locale LRBLF<j> est reliée à la ligne de bit de lecture globale GRBLF<j> correspondante par un circuit de liaison 31, par exemple du type décrit en relation avec la figure 4.

Dans la variante de la figure 10, le circuit mémoire comprend en outre, pour chaque colonne de rang j de la ou des matrices du module, un circuit de liaison supplémentaire 1001, connecté d'une part aux lignes de bit de lecture locales LRBLT<j> et LRBLF<j> de la colonne, et d'autre part aux lignes de bit de lecture globales GRBLT<j> et GRBLF<j> de la colonne. Le circuit de liaison supplémentaire 1001 est adapté à mettre en oeuvre des opérations de calcul logique ayant pour opérandes des données binaires appliquées sur les lignes de bit de lecture locales LRBLT<j> et LRBLF<j> de la colonne, et à fournir les résultat de ces opérations sur les lignes de bit de lecture globales GRBLT<j> et GRBLF<j> de la colonne. Sur la figure 10, seul un circuit de liaison supplémentaire 1001 du module a été représenté, ainsi qu'un circuit 1003 de précharge des lignes de bit de lecture globales GRBLT<j> et GRBLF<j> connectées au circuit 1001.

Le circuit de liaison supplémentaire 1001 de la figure 10 comprend un transistor 1102, par exemple un transistor MOS à canal N, reliant, par ses noeuds de conduction, la ligne de bit de lecture globale GRBLT<j> à un noeud intermédiaire n1 du circuit. Le circuit 1001 comprend en outre un transistor 1104, par exemple un transistor MOS à canal N, reliant, par ses noeuds de conduction, un noeud intermédiaire n2 du circuit à un noeud d'application du potentiel d'alimentation bas GND du module. Le circuit 1001 comprend en outre un transistor 1106, par exemple un transistor MOS à canal N, reliant, par ses noeuds de conduction, la ligne de bit de lecture globale GRBLF<j> à un noeud intermédiaire n3 du circuit. Le circuit 1001 comprend en outre un transistor 1108, par exemple un transistor MOS à canal N, reliant, par ses noeuds de conduction, un noeud intermédiaire n4 du circuit à un noeud d'application du potentiel d'alimentation bas GND du module. La grille du transistor 1106 est reliée, par exemple connectée, à la ligne de bit de lecture locale LRBLT<j> connectée au circuit 1001. La grille du transistor 1104 est reliée, par exemple connectée, à la ligne de bit de lecture locale LRBLF<j> connectée au circuit 1001. La grille du transistor 1102 est reliée, par exemple connectée, à un noeud L̅R̅B̅L̅T̅ <̅j̅>̅ de fourniture d'un signal binaire complémentaire du signal binaire porté par la ligne de bit de lecture locale LRBLT<j>. A titre d'exemple, le noeud L̅R̅B̅L̅T̅ <̅j̅>̅ est un noeud de sortie d'un inverseur (non représenté) dont l'entrée est reliée à la ligne de bit de lecture locale LRBLT<j>. La grille du transistor 1108 est reliée, par exemple connectée, à un noeud L̅R̅B̅L̅F̅ <̅j̅>̅ de fourniture d'un signal binaire complémentaire du signal binaire porté par la ligne de bit de lecture locale LRBLF<j>. A titre d'exemple, le noeud L̅R̅B̅L̅F̅ <̅j̅>̅ est un noeud de sortie d'un inverseur (non représenté) dont l'entrée est reliée à la ligne de bit de lecture locale LRBLF<j>. Le circuit 1001 de la figure 10 comprend de plus un premier interrupteur S1 reliant le noeud n1 au noeud n2, un deuxième interrupteur S2 reliant le noeud n3 au noeud n4, un troisième interrupteur S3 reliant le noeud n2 au noeud n3, et un quatrième interrupteur S4 reliant le noeud n1 au noeud n4.

Dans cet exemple, le circuit de précharge 1003 comprend un transistor 1201, par exemple un transistor MOS à canal P, reliant, par ses noeuds de conduction, un noeud d'application du potentiel d'alimentation haut VDD du module à la ligne de bit de lecture globale GRBLT<j>, et un transistor 1203, par exemple un transistor MOS à canal P, reliant, par ses noeuds de conduction, le noeud d'application du potentiel d'alimentation haut VDD du module à la ligne de bit de lecture globale GRBLF<j>. Dans l'exemple représenté, les transistors 1201 et 1203 ont leurs grilles de commande connectées à un même noeud de commande PCHB du circuit de précharge.

Le circuit de liaison supplémentaire 1001 de la figure 10 permet de mettre en oeuvre des opérations de calcul logique ayant pour opérandes des données binaires stockées dans les cellules connectées aux lignes de bit de lecture locales LRBLT<j> et LRBLF<j>.

Pour cela, les lignes de bit de lecture globales GRBLT<j> et GRBLF<j> sont d'abord préchargées à un niveau haut par l'intermédiaire du circuit de précharge 1003 (en mettant simultanément à l'état passant, puis à l'état bloqué les transistors 1201 et 1203 du circuit 1003, par application d'un signal de commande approprié sur le noeud PCHB).

A titre d'exemple illustratif, on considère que deux cellules élémentaires 10 d'une même colonne de rang j sont activées simultanément en lecture, la première via son port RPT (figure 2) seulement, et la deuxième via son port RPF (figure 2) seulement. Pour cela, après avoir préchargé à un niveau haut les lignes de bit de lecture LRBLT<j> et LRBLF<j> de la colonne et mis à un niveau bas les pistes conductrices de référence VGNDT et VGNDF de la colonne, le transistor de sélection T4 (figure 2) de la première cellule et le transistor de sélection T6 (figure 2) de la deuxième cellule sont simultanément rendus passant. Le transistor de sélection T6 de la première cellule et le transistor de sélection T4 de la deuxième cellule sont quant à eux maintenus ouverts (bloqués).

On désigne respectivement par A et B les valeurs binaires mémorisées sur les noeuds BLTI (figure 2) des deux cellules considérées. Les valeurs binaires complémentaires A̅ et B̅ sont alors stockées sur les noeuds BLFI (figure 2) respectifs des deux cellules. La piste conductrice de sortie LRBLT<j> de la colonne reste à son niveau haut de précharge uniquement si la valeur A est à un niveau bas, et la piste conductrice de sortie LRBLF<j> de la colonne reste à son niveau haut de précharge uniquement si la valeur B est à un niveau haut. Ainsi, le signal appliqué sur la grille du transistor 1106 correspond à la valeur complémentaire de la valeur A, c'est-à-dire qu'il est à un niveau bas si la valeur A est à un niveau haut, et à un niveau bas si la valeur A est à un niveau haut. Le signal appliqué sur la grille du transistor 1102 correspond quant à lui à la valeur A, c'est-à-dire qu'il est à un niveau haut si la valeur A est à un niveau haut, et à un niveau bas si la valeur A est à un niveau bas. Le signal appliqué sur la grille du transistor 1104 et sur la grille du transistor 1108 correspondent quant à eux respectivement à la valeur B et à la valeur complémentaire de la valeur B.

Le circuit de liaison supplémentaire 1001 peut être commandé dans une première configuration dans laquelle les interrupteurs S1 et S2 sont fermés (passants) et les interrupteurs S3 et S4 sont ouverts (bloqués), ou dans une deuxième configuration dans laquelle les interrupteurs S1 et S2 sont ouverts (bloqués) et les interrupteurs S3 et S4 sont fermés (passants).

Dans la première configuration (interrupteurs S1 et S2 fermés et interrupteurs S3 et S4 ouverts), la ligne de bit de lecture globale GRBLT<j> se décharge uniquement si les valeurs A et B sont toutes les deux à l'état haut, et la ligne de bit de lecture globale GRBLF<j> se décharge uniquement si les signaux A et B sont tous les deux à l'état bas. Autrement dit, le signal binaire lu sur la ligne de bit de lecture globale GRBLT<j> correspond au résultat d'une opération logique NON ET entre les valeurs A et B (A̅.̅B̅), et le signal binaire lu sur la ligne de bit de lecture globale GRBLF<j> correspond au résultat d'une opération logique NON ET entre les valeurs A̅ et B̅, c'est-à-dire au résultat d'une opération logique OU entre les valeurs A et B (A+B).

Un avantage de cette configuration est que les opérations logiques A̅.̅B̅ et A+B sont réalisées en local, seul le résultat de chaque opération étant transmis sur la ligne de bit de lecture globale GRBLT<j>, respectivement GRBLF<j>. Ceci permet un gain en consommation associé à deux calculs primitifs en parallèle. En effet, en observant les tables de vérité reproduites ci-dessous des opérations A̅.̅B̅ et A+B, on peut voir qu'en reportant uniquement le résultat des opérations logiques A̅.̅B̅ et A+B sur les lignes de bit de lecture globales, il y a, statistiquement, une chance sur quatre de décharger chaque ligne de bit de lecture globale.

| A | B | A̅.̅B̅ | A+B |
|---|---|---|---|
| 0 | 0 | 1 | 0 |
| 0 | 1 | 1 | 1 |
| 1 | 0 | 1 | 1 |
| 1 | 1 | 0 | 1 |

Si au contraire les lignes de bit de lecture globales étaient utilisées pour lire directement les valeurs A et B, il y aurait, statistiquement, une chance sur deux de décharger chaque ligne de bit de lecture globale.

Or, du fait de la capacité relativement élevée des lignes de bit de lecture globales, les opérations de recharge des lignes de bit de lecture globales sont relativement coûteuses en énergie par rapport aux opérations de recharge des lignes de bit de lecture locales. Le circuit de liaison supplémentaire 1001 permet ainsi de réaliser un gain en consommation dynamique.

On notera que les opérations logiques A̅.̅B̅ et A+B sont particulièrement utiles dans la mesure où elles constituent des opérations élémentaires nécessaires à la mise en oeuvre d'opérations arithmétiques d'addition.

Dans la deuxième configuration du circuit de liaison 1001 (interrupteurs S3 et S4 fermés et interrupteurs S1 et S2 ouverts), le fonctionnement est similaire à la différence près que les opérations logiques réalisées sont les opérations A̅ + B (le résultat de l'opération étant disponible sur la ligne de bit de lecture globale GRBLT<j>) et *A* + B̅ (le résultat de l'opération étant disponible sur la ligne de bit de lecture globale GRBLF<j>). Ces deux opérations sont elles aussi particulièrement utiles dans la mesure où elles constituent des opérations élémentaires nécessaires à la mise en oeuvre d'opérations arithmétiques de soustraction. Là encore, l'utilisation du circuit de liaison supplémentaire 1001 pour la mise en oeuvre de ces opérations permet un gain en consommation dynamique associé à deux calculs primitifs en parallèle.

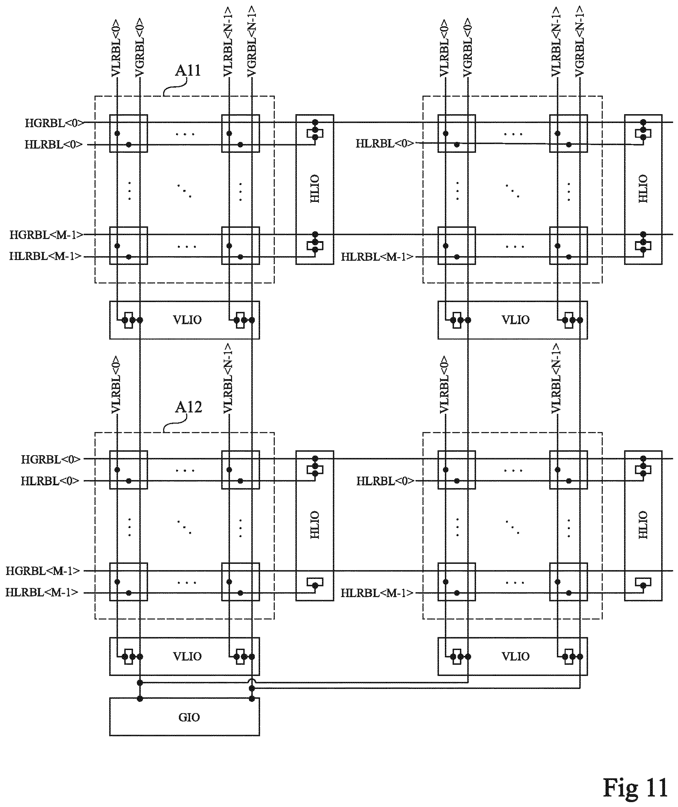

La figure 11 illustre une autre variante d'un module mémoire selon un mode de réalisation.

Le module mémoire de la figure 11 reprend les mêmes éléments que le module mémoire de la figure 3, agencés sensiblement de la même manière. Toutefois, en figure 11, les matrices A1 et A2 de la figure 3 sont référencées respectivement A11 et A12. De plus, les lignes de bit de lecture locales LRBL<j> de la figure 3, aussi appelées lignes de bit de lecture locales verticales, sont référencées VLRBL<j>, et les lignes de bit de lecture globales GRBL<j> de la figure 3, aussi appelées lignes de bit de lecture globales verticales, sont référencées VGRBL<j>. En outre, les circuits d'entrée-sortie locaux LIO de la figure 3, aussi appelés circuits d'entrée-sortie locaux verticaux, sont référencés respectivement VLIO. Sur la figure 11, par souci de simplification, les circuits de sélection de rangée RS et de contrôle CTRL du module mémoire n'ont pas été représentés.

Le module mémoire de la figure 11 comprend en outre deux matrices de cellules élémentaires 10 supplémentaires A21 et A22, de mêmes dimensions que les matrices A11 et A12, les matrices A11, A12, A21 et A22 étant disposées selon une matrice de deux rangées par deux colonnes. Plus particulièrement, dans cet exemple, les matrices A11 et A21 forment une première rangée de la matrice de matrices, et les matrices A12 et A22 forment une deuxième rangée de la matrice de matrices.

Comme dans les matrices A11 et A12, dans chacune des matrices A21 et A22 du module mémoire, les cellules élémentaires 10 d'une même colonne de la matrice sont directement connectées (sans circuit de liaison intermédiaire) à une même ligne de bit de lecture locale verticale VLRBL<j> de la matrice.

De plus, comme pour les matrices A11 et A12, pour chacune des matrices A21 et A22, le module mémoire comprend un circuit d'entrée-sortie local vertical VLIO spécifique à la matrice, par exemple disposé à une extrémité des colonnes de la matrice, auquel sont connectées les lignes de bit de lecture locales verticales VLRBL<j> de la matrice. Les lignes de bit de lecture locales verticales VLRBL<j> des différentes matrices ne sont en revanche pas directement connectées entre elles.

Pour chaque rang de colonne j des matrices A21 et A22, le module mémoire comprend en outre une ligne de bit globale verticale VGRBL<j> commune aux cellules des colonnes de rang j des matrices A21 et A22, à laquelle sont reliées les lignes de bit de lecture locales VLRBL<j> des matrices A21 et A22. De même que les lignes de bit de lecture locales VLRBL<j>, les lignes de bit de lecture globales VGRBL<j> s'étendent dans la direction des colonnes des matrices A21 et A22, c'est-à-dire verticalement dans l'orientation de la figure 11.

Comme pour les matrices A11 et A12, pour chacune des matrices A21 et A22 du module, le circuit d'entrée-sortie local vertical VLIO associé à la matrice comprend, pour chaque colonne de la matrice, un circuit de liaison 31 reliant la ligne de bit de lecture locale VLRBL<j> de la colonne à la ligne de bit de lecture globale VGRBL<j> de cette même colonne.

Les lignes de bit de lecture globales verticales VGRBL<j> sont connectées à un même circuit d'entrée-sortie global GIO du module, commun aux matrices A11, A12, A21 et A22 du module. Dans l'exemple représenté, le circuit d'entrée-sortie global GIO est de dimension N (N étant le nombre de cellules élémentaires par rangée dans chacune des matrices A11, A12, A21 et A22 du module). Autrement dit, dans cet exemple, les lignes de bit globales verticales VGRBL<j> de même rang j du module sont reliées entre elles, par exemple connectées entre elles, au niveau du circuit d'entrée-sortie global GIO du module.

Dans chacune des matrices A11, A12, A21 et A22 du module mémoire de la figure 11, les cellules élémentaires 10 d'une même rangée de la matrice sont en outre directement connectées (sans circuit de liaison intermédiaire) à une même piste conductrice de sortie ou ligne de bit de lecture locale horizontale HLRBL de la matrice, étant entendu que les cellules élémentaires 10 de rangées distinctes sont connectées à des lignes de bit de lecture locales horizontales HLRBL distinctes. Autrement dit, pour chaque rangée de rang i de la matrice, où i est un entier allant de 0 à M-1, M désignant le nombre de rangées de la matrice, la matrice comprend une ligne de bit de lecture locale horizontale HLRBL<i> spécifique à la rangée, connectant entre elles les cellules de la rangée.

Par rapport à l'exemple de la figure 2, chaque cellule élémentaire 10 peut comprendre un ou plusieurs transistors supplémentaires reliant le noeud de stockage BLTI de la cellule à la ligne de bit de lecture locale horizontale HLRBL<i> de la rangée à laquelle appartient la cellule. A titre d'exemple, chaque cellule élémentaire 10 peut comprendre un port d'accès additionnel RPT', identique ou similaire au port RPT, reliant le noeud de stockage BLTI de la cellule à la ligne de bit de lecture locale horizontale HLRBL<i> de la rangée à laquelle appartient la cellule.

Pour chacune des matrices A11, A12, A21 et A22, le module mémoire comprend un circuit d'entrée-sortie local horizontal HLIO spécifique à la matrice, par exemple disposé à une extrémité des rangées de la matrice, auquel sont connectées les lignes de bit de lecture locales horizontales HLRBL<i> de la matrice. Les lignes de bit de lecture locales horizontales HLRBL<i> des différentes matrices ne sont en revanche pas directement connectées entre elles.

Pour chaque indice de rangée i des matrices A11 et A21, le module comprend en outre une piste conductrice HGRBL<i> commune aux cellules des rangées de rang i des matrices A11 et A21, appelée ligne de bit de lecture globale horizontale, à laquelle sont reliées les lignes de bit de lecture locales horizontales HLRBL<i> des matrices A11 et A21. De même que les lignes de bit de lecture locales horizontales HLRBL<i>, les lignes de bit de lecture globales horizontales HGRBL<i> s'étendent dans la direction des rangées des matrices A11 et A21, c'est-à-dire horizontalement dans l'orientation de la figure 11. De façon similaire, pour chaque indice de rangée i des matrices A12 et A22, le module comprend une ligne de bit globale horizontale HGRBL<i> à laquelle sont reliées les lignes de bit de lecture locales horizontales HLRBL<i> des matrices A12 et A22.

Pour chacune des matrices A11, A12, A21 et A22 du module, le circuit d'entrée-sortie local horizontal HLIO associé à la matrice comprend, pour chaque rangée de la matrice, un circuit de liaison 31 reliant la ligne de bit de lecture locale HLRBL<i> de la rangée à la ligne de bit de lecture globale HGRBL<i> de cette même rangée. Le circuit de liaison 31, par exemple identique ou similaire au circuit 31 de la figure 4, est commandable pour transférer un signal binaire de la ligne de bit de lecture locale HLRBL<i> vers la ligne de bit de lecture globale HGRBL<i>, ou pour transférer un signal binaire de la ligne de bit de lecture globale HGRBL<i> vers la ligne de bit de lecture locale HLRBL<i>, ou pour isoler la ligne de bit de lecture locale HLRBL<i> de la ligne de bit de lecture globale HGRBL<i>.

Les lignes de bit de lecture globales horizontales HGRBL<i> peuvent être connectées à un même circuit d'entrée-sortie global horizontal du module (non représenté sur la figure 11), commun aux matrices A11, A12, A21 et A22 du module. A titre d'exemple, le circuit d'entrée-sortie global horizontal est de dimension M (M étant le nombre de cellules élémentaires par colonne dans chacune des matrices A11, A12, A21 et A22 du module) . Dans ce cas, les lignes de bit globales horizontales HGRBL<i> de même rang i du module sont reliées entre elles, par exemple connectées entre elles, au niveau du circuit d'entrée-sortie global horizontal du module.

Une commande appropriée des circuits de liaison 31 permet la mise en oeuvre d'opérations de calcul ayant pour opérandes des données stockées dans différentes matrices du module, quelles que soient les positions desdites matrices dans le module.

Un avantage de l'agencement décrit en relation avec la figure 11 est qu'il permet de faire transiter des données d'une ligne de bit locale ou globale verticale vers une ligne de bit locale ou globale horizontale.

Pour permettre la réécriture du résultat d'une opération de calcul ou de lecture réalisée via les lignes de bit de lecture horizontales du module, sans faire transiter la donnée calculée ou lue par des circuits externes au module mémoire, et notamment par un bus de données externe au module, chaque circuit d'entrée-sortie local horizontal HLIO du module mémoire peut comprendre un circuit interne de redirection (non détaillé) permettant de relier la ou les lignes de bit de lecture locales de chaque rangée de la matrice correspondante à une ligne de bit d'écriture de donnée de la rangée et/ou d'une autre rangée de la matrice, ou encore à une ligne de bit d'écriture de donnée d'une colonne de la matrice.

Bien entendu, le nombre de matrices du module et la disposition des matrices dans le module peuvent être différents de ce qui a été représenté et décrit en relation avec la figure 11.

Par ailleurs, de façon similaire à ce qui a été décrit en relation avec la figure 11, les modes de réalisation des figures 5, 6, 8 et 9 peuvent être adaptés de façon à prévoir, dans chaque matrice, des lignes de bit de lecture locales horizontales directement connectées aux cellules élémentaires de la matrice, et des lignes de bit de lecture globales horizontales reliées aux lignes de bit de lecture locales horizontales par des circuits de liaison 31.

Des modes de réalisation particuliers ont été décrits. Diverses variantes et modifications apparaîtront à l'homme de l'art. En particulier, les modes de réalisation décrits ne se limitent pas à l'exemple de réalisation des cellules élémentaires 10 décrit en relation avec la figure 2, ni aux exemples de réalisation de circuits de liaison décrits en relation avec les figures 4 et 7. Plus généralement, l'homme du métier saura mettre en oeuvre le fonctionnement recherché avec d'autres architectures de cellules élémentaires et/ou de circuits de liaison internes (les circuits 31) ou externes (les circuits 61) aux modules mémoire.

On notera de plus que les modes de réalisation décrits en relation avec les figures 5, 6, 7, 8 et 9 et le mode de réalisation décrit en relation avec les figures 3 et 4 peuvent être combinés, c'est-à-dire que des modules partitionnés en plusieurs matrices (tel que décrit en relation avec les figures 3 et 4) peuvent être reliés par des circuits de liaison externes 61 au sein d'un même circuit mémoire (tel que décrit en relation avec les figures 5, 6, 7, 8 et 9.

Par ailleurs, on a décrit ci-dessus des exemples de réalisation dans lesquels des lignes de bit de lecture globales et des circuits de liaison sont utilisés pour relier entre elles des lignes de bit de lecture locales de plusieurs matrices de cellules élémentaires d'un même module mémoire ou d'un même circuit mémoire, en vue de réaliser des opérations de calcul ayant pour opérandes des données stockées dans différentes matrices du module ou du circuit.

Plus généralement, l'architecture proposée peut être utilisée pour transférer des données d'une matrice à une autre pour d'autres applications que la mise en oeuvre d'une opération de calcul.

A titre d'exemple, dans une première matrice, les lignes de bit globales de la matrice peuvent être reliées aux lignes de bit de lecture locales de la matrice tel que décrit ci-dessus, tandis que, dans une deuxième matrice, les lignes de bit globales peuvent être reliées à des lignes de bit d'écriture de la matrice, de façon à permettre un transfert direct de données lues dans la première matrice en vue de leur écriture dans la deuxième matrice.

A titre de variante, le module ou le circuit mémoire peut comprendre des matrices de cellules élémentaires de natures différente, par exemple une première matrice de cellules SRAM du type décrit en relation avec la figure 2, et une deuxième matrice de cellules CAM (de l'anglais "Content Adressable Memory" - mémoire adressable par le contenu). Dans ce cas, les lignes de bit globales de la première matrice peuvent être reliées aux lignes de bit de lecture locales de la matrice tel que décrit ci-dessus, tandis que, les lignes de bit globales de la deuxième matrice peuvent être reliées à des lignes de bit de recherche de contenu de la deuxième matrice, de façon à permettre un transfert direct des données lues dans la première matrice en vue d'effectuer des recherches de contenu dans la deuxième matrice.

En outre, les modes de réalisation décrits ne se limitent pas aux exemples décrits ci-dessus dans lesquels les cellules élémentaires du circuit mémoire sont des cellules de type SRAM. Plus généralement, les modes de réalisation décrits peuvent s'appliquer à d'autres technologies de cellules, par exemple des cellules de type ReRAM (mémoire résistive non volatile) ou des cellules de type DRAM (mémoire dynamique capacitive).

A titre d'exemple, pour réaliser un circuit mémoire de type ReRAM, on peut prévoir, dans la cellule 12 de la figure 2, de remplacer l'association en antiparallèle de deux inverseurs par une association en série de deux éléments résistifs à résistance programmable, une première extrémité de ladite association en série étant reliée à un noeud d'application d'un potentiel d'alimentation haut de la cellule, la deuxième extrémité de ladite association en série étant reliée à un noeud d'application d'un potentiel d'alimentation bas de la cellule, et le noeud intermédiaire de ladite association en série, ou point milieu entre les deux éléments résistifs, formant le noeud de stockage BLTI de la cellule.

A titre de variante, pour réaliser un circuit mémoire de type DRAM, on peut prévoir, dans la cellule 12 de la figure 2, de remplacer l'association en antiparallèle de deux inverseurs par un élément capacitif ayant une première électrode reliée, par exemple connectée, au noeud BLTI, et une deuxième électrode reliée, par exemple connectée, à un noeud d'application d'un potentiel de référence de la cellule.

## Revendications

1. Circuit mémoire comprenant K*P*M*N cellules élémentaires (10) réparties en K*P matrices locales (A1, A2 ; A ; A11, A12, A21, A22) comprenant chacune M rangées et N colonnes, les K*P matrices étant elles-mêmes agencées en une matrice globale de K rangées et P colonnes, avec :
- K, P, M et N entiers supérieurs ou égaux à 2,
- l entier allant de 0 à K-1 et q entier allant de 0 à P-1 désignant respectivement le rang de la rangée et le rang de la colonne de chaque matrice locale dans la matrice globale,
- i entier allant de 0 à M-1 et j entier allant de 0 à N-1 désignant respectivement le rang de la rangée et le rang de la colonne de chaque cellule élémentaire (10) dans la matrice locale à laquelle elle appartient, dans lequel :
chaque colonne de chaque matrice locale comprend une ligne de bit locale verticale (LRBL<j> ; LRBLT<j> ; VLRBL<j>) directement connectée à chacune des cellules de la colonne ;
chaque colonne de chaque matrice locale comprend une ligne de bit globale verticale (VGRBL<j>) reliée à la ligne de bit locale verticale (LRBL<j> ; LRBLT<j> ; VLRBL<j>) de la colonne par un circuit de liaison local (31), le circuit de liaison local (31) étant commandable pour :
- isoler la ligne de bit locale verticale de la ligne de bit globale verticale,
- transmettre sur la ligne de bit globale verticale un signal binaire présent sur la ligne de bit locale verticale, ou
- transmettre sur la ligne de bit locale verticale un signal binaire présent sur la ligne de bit globale verticale ;
dans chaque colonne de rang q de la matrice globale, pour chaque rang j de colonne des matrices locales, les K lignes de bit globales verticales (VGRBL<j>) de même rang j sont reliées entre elles ;
**caractérisé en ce que** le circuit mémoire comprend en outre, pour chaque colonne de chaque matrice locale, une ligne de bit globale horizontale (HGRBL<j>) connectée à la ligne de bit globale verticale de la colonne ; et
dans chaque rangée de rang l de la matrice globale, pour chaque rang j de colonne des matrices locales, les P lignes de bit globales horizontales (HGRBL<j>) de même rang j sont reliées entre elles.

2. Circuit mémoire selon la revendication 1, dans lequel, dans chaque colonne de chaque matrice locale, le circuit de liaison local (31) comprend :
des premier (401) et deuxième (403) transistors connectés en série entre un noeud (VDD) d'application d'une tension d'alimentation du circuit et la ligne de bit globale verticale (VGRBL<j>) de la colonne ; et
des troisième (405) et quatrième (407) transistors connectés en série entre la ligne de bit locale verticale (LRBL<j> ; LRBLT<j>) de la colonne et un noeud (GND) d'application d'un potentiel de référence du circuit,
la grille du deuxième transistor (403) étant connectée à la ligne de bit locale verticale (LRBL<j> ; LRBLT<j>) de la colonne, et la grille du troisième transistor (405) étant connectée à la ligne de bit globale verticale (VGRBL<j>) de la colonne.

3. Circuit mémoire selon la revendication 1 ou 2, dans lequel :
les matrices locales (A1, A2) font partie d'un même module mémoire ;
dans chaque colonne de rang q de la matrice globale, pour chaque rang j de colonne des matrices locales, les K lignes de bit globales verticales (VGRBL<j>) de même rang j sont directement connectées entre elles ; et
dans chaque rangée de rang l de la matrice globale, pour chaque rang j de colonne des matrices locales, les P lignes de bit globales horizontales (HGRBL<j>) de même rang j sont directement connectées entre elles.

4. Circuit mémoire selon la revendication 1 ou 2, dans lequel :
les matrices locales (A) font partie de modules mémoire distincts ;
dans chaque colonne de rang q de la matrice globale, pour chaque rang j de colonne des matrices locales, les K lignes de bit globales verticales (VGRBL<j>) de même rang j sont reliées en série par l'intermédiaire de K-1 circuits de liaison globaux (61) ; et
dans chaque rangée de rang l de la matrice globale, pour chaque rang j de colonne des matrices locales, les P lignes de bit globales horizontales (HGRBL<j>) de même rang j sont reliées en série par l'intermédiaire de P-1 circuits de liaison globaux (61) .

5. Circuit mémoire selon la revendication 4, dans lequel chaque circuit de liaison global (61) reliant en série une première ligne de bit globale d'un module mémoire à une deuxième ligne de bit globale d'un module mémoire voisin, est commandable pour :
- isoler les première et deuxième lignes de bit globales l'une de l'autre,
- recopier sur la deuxième ligne de bit globale un signal binaire présent sur la première ligne de bit globale, ou
- recopier sur la première ligne de bit globale un signal binaire présent sur la deuxième ligne de bit globale.

6. Circuit mémoire selon la revendication 5, dans lequel chaque circuit de liaison global (61) comprend :
un amplificateur (701) ayant une entrée reliée à la première ligne de bit globale par un cinquième transistor (703) et une sortie reliée à la deuxième ligne de bit globale par un sixième transistor (705) ;
un septième transistor (707) reliant la première ligne de bit globale à la sortie de l'amplificateur (701) ; et
un huitième transistor (709) reliant la deuxième ligne de bit globale à l'entrée de l'amplificateur (701).

7. Circuit mémoire selon la revendication 6, dans lequel, dans chaque circuit de liaison global (61), les grilles des cinquième (703) et sixième (705) transistors sont connectées à une même première piste conductrice de commande (T2B_SEL) du circuit de liaison global, et les grilles des septième (707) et huitième (709) transistors sont connectées à une même deuxième piste conductrice de commande (B2T_SEL) du circuit de liaison global.

8. Circuit mémoire selon l'une quelconque des revendications 1 à 7, comprenant un circuit de contrôle adapté à activer simultanément en lecture une première cellule d'une colonne de rang j d'une première matrice locale du circuit mémoire, et une deuxième cellule d'une colonne de même rang j d'une deuxième matrice locale du circuit mémoire, et à commander le ou les circuits de liaison (31 ; 61) reliant la ligne de bit locale verticale (LRBL<j> ; LRBLT<j>) de la colonne de rang j de la première matrice locale à la ligne de bit locale verticale (LRBL<j> ; LRBLT<j>) de la colonne de rang j de la deuxième matrice locale, pour transmettre sur la ligne de bit locale verticale de la colonne de rang j de la deuxième matrice locale un signal binaire présent sur la ligne de bit locale verticale de la colonne de rang j de la première matrice locale, de façon à réaliser une opération logique ayant pour opérandes les données stockées dans les première et deuxième cellules.

9. Circuit mémoire selon l'une quelconque des revendications 1 à 8, dans lequel :
chaque colonne de chaque matrice locale comprend une ligne de bit locale verticale complémentaire (LRBLF<j>) directement connectée à chacune des cellules de la colonne ;
chaque colonne de chaque matrice locale comprend une ligne de bit globale verticale complémentaire (GRBLF<j>) reliée à la deuxième ligne de bit locale (LRBLF<j>) de la colonne par un circuit de liaison local (31) commandable pour :
- isoler la ligne de bit locale verticale complémentaire de la ligne de bit globale verticale complémentaire,
- transmettre sur la ligne de bit globale verticale complémentaire un signal binaire présent sur la ligne de bit locale verticale complémentaire, ou
- transmettre sur la ligne de bit locale verticale complémentaire un signal binaire présent sur la ligne de bit globale verticale complémentaire ;
dans chaque colonne de rang q de la matrice globale, pour chaque rang j de colonne des matrices locales, les K lignes de bit globales verticales complémentaires (VGRBL<j>) de même rang j sont reliées entre elles ;
le circuit mémoire comprend en outre, pour chaque colonne de chaque matrice locale, une ligne de bit globale horizontale complémentaire (HGRBL<j>) connectée à la ligne de bit globale verticale complémentaire de la colonne ; et
dans chaque rangée de rang l de la matrice globale, pour chaque rang j de colonne des matrices locales, les P lignes de bit globales horizontales complémentaire (HGRBL<j>) de même rang j sont reliées entre elles.

10. Circuit mémoire selon la revendication 9, comprenant en outre, pour chaque colonne de chaque matrice locale, un circuit additionnel (1001) connecté à la ligne de bit locale verticale, à la ligne de bit locale verticale complémentaire, à la ligne de bit globale verticale, et à la ligne de bit globale verticale complémentaire de la colonne, le circuit additionnel (1001) étant adapté à mettre en oeuvre des opérations de calcul logique ayant pour opérandes des données binaires appliquées la ligne de bit locale verticale et sur la ligne de bit locale verticale complémentaire de la colonne et à fournir les résultats de ces opérations sur la ligne de bit globale verticale et sur la ligne de bit globale verticale complémentaire de la colonne.

11. Circuit mémoire selon la revendication 10, dans lequel le circuit additionnel (1001) comprend :
un premier transistor (1102) reliant la ligne de bit globale verticale (GRBLT<j>) à un premier noeud intermédiaire (n1) ;
un deuxième transistor (1104) reliant un deuxième noeud intermédiaire (n2) à un noeud d'application d'un potentiel d'alimentation bas (GND) du circuit mémoire ;
un troisième transistor (1106) reliant la ligne de bit globale verticale complémentaire (GRBLF<j>) à un troisième noeud intermédiaire (n3) ;
un quatrième transistor (1108) reliant un quatrième noeud intermédiaire (n4) au noeud d'application du potentiel d'alimentation bas (GND) du circuit mémoire ;
un premier interrupteur (S1) reliant le premier noeud intermédiaire (n1) au deuxième noeud intermédiaire (n2) ;
un deuxième interrupteur (S2) reliant le troisième noeud intermédiaire (n3) au quatrième noeud intermédiaire (n4) ;
un troisième interrupteur (S3) reliant le deuxième noeud intermédiaire (n2) au troisième noeud intermédiaire (n3) ; et
un quatrième interrupteur (S4) reliant le premier noeud intermédiaire (n1) au quatrième noeud intermédiaire (n4).

12. Circuit mémoire selon la revendication 11, dans lequel :
la grille du troisième transistor (1106) du circuit additionnel est reliée à la ligne de bit locale verticale (LRBLT<j>) de la colonne ;
la grille du deuxième transistor (1104) du circuit additionnel est reliée à la ligne de bit locale verticale complémentaire (LRBLF<j>) de la colonne ;
la grille du premier transistor (1102) du circuit additionnel est reliée à un noeud (L̅R̅B̅L̅T̅ <̅j̅>̅) de fourniture d'un signal binaire complémentaire du signal binaire porté par la ligne de bit de lecture locale verticale (LRBLT<j>) de la colonne ; et
la grille du quatrième transistor (1108) est reliée à un noeud (L̅R̅B̅L̅F̅ <̅j̅>̅) de fourniture d'un signal binaire complémentaire du signal binaire porté par la ligne de bit de lecture locale verticale complémentaire (LRBLF<j>) de la colonne.

13. Circuit mémoire comprenant K*P*M*N cellules élémentaires (10) réparties en K*P matrices locales (A1, A2 ; A ; A11, A12, A21, A22) comprenant chacune M rangées et N colonnes, les K*P matrices étant elles-mêmes agencées en une matrice globale de K rangées et P colonnes, avec :
- K, P, M et N entiers supérieurs ou égaux à 2,
- l entier allant de 0 à K-1 et q entier allant de 0 à P-1 désignant respectivement le rang de la rangée et le rang de la colonne de chaque matrice locale dans la matrice globale,
- i entier allant de 0 à M-1 et j entier allant de 0 à N-1 désignant respectivement le rang de la rangée et le rang de la colonne de chaque cellule élémentaire (10) dans la matrice locale à laquelle elle appartient, dans lequel :
chaque colonne de chaque matrice locale comprend une ligne de bit locale verticale (LRBL<j> ; LRBLT<j> ; VLRBL<j>) directement connectée à chacune des cellules de la colonne ;
chaque colonne de chaque matrice locale comprend une ligne de bit globale verticale (VGRBL<j>) reliée à la ligne de bit locale verticale (LRBL<j> ; LRBLT<j> ; VLRBL<j>) de la colonne par un circuit de liaison local (31), le circuit de liaison local (31) étant commandable pour :
- isoler la ligne de bit locale verticale de la ligne de bit globale verticale,
- transmettre sur la ligne de bit globale verticale un signal binaire présent sur la ligne de bit locale verticale, ou
- transmettre sur la ligne de bit locale verticale un signal binaire présent sur la ligne de bit globale verticale ;
dans chaque colonne de rang q de la matrice globale, pour chaque rang j de colonne des matrices locales, les K lignes de bit globales verticales (VGRBL<j>) de même rang j sont reliées entre elles ;
**caractérisé en ce que** le circuit mémoire comprends en outre, chaque rangée de chaque matrice locale comprend une ligne de bit locale horizontale (HLRBL<i>) directement connectée à chacune des cellules de la rangée ;
chaque rangée de chaque matrice locale comprend une ligne de bit globale horizontale (HGRBL<i>) reliée à la ligne de bit locale horizontale (HLRBL<i>) de la rangée par un circuit de liaison local (31), le circuit de liaison local (31) étant commandable pour :
- isoler la ligne de bit locale horizontale de la ligne de bit globale horizontale,
- transmettre sur la ligne de bit globale horizontale un signal binaire présent sur la ligne de bit locale horizontale, ou
- transmettre sur la ligne de bit locale horizontale un signal binaire présent sur la ligne de bit globale horizontale ;
dans chaque rangée de rang l de la matrice globale, pour chaque rang i de rangée des matrices locales, les P lignes de bit globales horizontales (VGRBL<j>) de même rang i sont reliées entre elles.

## Patentansprüche

1. Eine Speicherschaltung mit K*P*M*N Elementarzellen (10), die in K*P lokalen Arrays (A1, A2; A; A11, A12, A21, A22) verteilt sind, die jeweils M Zeilen und N Spalten aufweisen, wobei die K*P-Arrays in einem globalen Array von K Zeilen und P Spalten angeordnet sind, mit:
- K, P, M und N ganzen Zahlen größer oder gleich 2,
- l eine ganze Zahl im Bereich von 0 bis K-1 und q eine ganze Zahl im Bereich von 0 bis P-1, die jeweils den Rang der Zeile und den Rang der Spalte jedes lokalen Arrays im globalen Array bezeichnen,
- i eine ganze Zahl im Bereich von 0 bis M-1 und j eine ganze Zahl im Bereich von 0 bis N-1 ist, die den Rang der Zeile bzw. den Rang der Spalte jeder Elementarzelle (10) in der lokalen Array, zu der sie gehört, bezeichnen, wobei
jede Spalte jedes lokalen Arrays eine vertikale lokale Bitleitung (LRBL<j>; LRBLT<j>; VLRBL<j>) aufweist, die direkt mit jeder der Zellen der Spalte verbunden ist;
jede Spalte jedes lokalen Arrays eine vertikale globale Bitleitung (VGRBL<j>) aufweist, die mit der vertikalen lokalen Bitleitung (LRBL<j>; LRBLT<j>; VLRBL<j>) der Spalte durch eine lokale Kopplungsschaltung (31) gekoppelt ist, wobei die lokale Kopplungsschaltung (31) steuerbar ist zum:
- Isolieren der vertikalen lokalen Bitleitung von der vertikalen globalen Bitleitung,
- Übertragen, über die vertikale globale Bitleitung, eines binären Signals, das auf der vertikalen lokalen Bitleitung vorhanden ist, oder
- Übertragen, über die vertikale lokale Bitleitung, eines binären Signals, das auf der vertikalen globalen Bitleitung vorhanden ist;
wobei in jeder Spalte vom Rang q im globalen Array, für jeden Spaltenrang j der lokalen Arrays die K vertikalen globalen Bitleitungen (VGRBL<j>), die den gleichen Rang j haben, miteinander gekoppelt sind;
**dadurch gekennzeichnet, dass** die Speicherschaltung ferner für jede Spalte jedes lokalen Arrays eine horizontale globale Bitleitung (HGRBL<j>) aufweist, die mit der vertikalen globalen Bitleitung der Spalte verbunden ist; und
in jeder Zeile des Rangs l im globalen Array werden für jeden Spaltenrang j der lokalen Arrays die P horizontalen globalen Bitleitungen (HGRBL<j>) mit dem gleichen Rang j miteinander gekoppelt.

2. Speicherschaltung nach Anspruch 1, wobei in jeder Spalte jedes lokalen Arrays die lokale Kopplungsschaltung (31) aufweist:
erste (401) und zweite (403) Transistoren, die zwischen einem Knoten (VDD) des Anlegens einer Versorgungsspannung der Schaltung und der vertikalen globalen Bitleitung (VGRBL<j>) der Spalte in Reihe geschaltet sind; und
dritte (405) und vierte (407) Transistoren, die zwischen der vertikalen lokalen Bitleitung (LRBL<j>; LRBLT<j>) der Spalte und einem Knoten (GND) des Anlegens eines Bezugspotentials der Schaltung in Reihe geschaltet sind,
wobei das Gate des zweiten Transistors (403) mit der vertikalen lokalen Bitleitung (LRBL<j>; LRBLT<j>) der Spalte verbunden ist und das Gate des dritten Transistors (405) mit der vertikalen globalen Bitleitung (VGRBL<j>) der Spalte verbunden ist.

3. Speicherschaltung nach Anspruch 1 oder 2, wobei:
die lokalen Arrays (A1, A2) zu einem gleichen Speichermodul gehören;
in jeder Spalte des Rangs q des globalen Arrays für jeden Spaltenrang j der lokalen Arrays die K vertikalen globalen Bitleitungen (VGRBL<j>) mit demselben Rang j direkt miteinander verbunden sind; und
in jeder Zeile des Rangs l des globalen Arrays für jeden Spaltenrang j der lokalen Arrays die P horizontalen globalen Bitleitungen (HGRBL<j>) mit dem gleichen Rang j direkt miteinander verbunden sind.

4. Speicherschaltung nach Anspruch 1 oder 2, wobei:
die lokalen Arrays (A) zu verschiedenen Speichermodulen gehören;
in jeder Spalte des Rangs q des globalen Arrays für jeden Spaltenrang j der lokalen Arrays die K vertikalen globalen Bitleitungen (VGRBL<j>) mit demselben Rang j über K-1 globale Kopplungsschaltungen (61) in Reihe geschaltet sind; und
in jeder Zeile des Rangs l des globalen Arrays für jeden Spaltenrang j der lokalen Arrays die P horizontalen globalen Bitleitungen (HGRBL<j>) mit dem gleichen Rang j über P-1 globale Kopplungsschaltungen (61) in Reihe geschaltet werden.

5. Speicherschaltung nach Anspruch 4, wobei jede globale Kopplungsschaltung (61), die eine erste globale Bitleitung eines Speichermoduls mit einer zweiten globalen Bitleitung eines benachbarten Speichermoduls in Reihe koppelt, steuerbar ist zum:
- Isolieren der ersten und zweiten globalen Bitleitung voneinande,
- Kopieren, auf die zweite globale Bitleitung, eines binären Signals, das auf der ersten globalen Bitleitung vorhanden ist, oder
- Kopieren, auf die erste globale Bitleitung, eines binären Signals, das auf der zweiten globalen Bitleitung vorhanden ist.

6. Speicherschaltung nach Anspruch 5, wobei jede globale Koppelungsschaltung (61) aufweist:
einen Verstärker (701) mit einem Eingang, der über einen fünften Transistor (703) an die erste globale Bitleitung gekoppelt ist, und einem Ausgang, der über einen sechsten Transistor (705) an die zweiten globalen Bitleitungen gekoppelt ist;
einen siebten Transistor (707), der die erste globale Bitleitung mit dem Ausgang des Verstärkers (701) koppelt; und
einen achten Transistor (709), der die zweite globale Bitleitung mit dem Eingang des Verstärkers (701) koppelt.

7. Speicherschaltung nach Anspruch 6, wobei in jeder globalen Kopplungsschaltung (61) die Gates des fünften (703) und sechsten (705) Transistors mit einer gleichen Steuerleiterbahn (T2B_SEL) der globalen Kopplungsschaltung verbunden sind und die Gates des siebten (707) und achten (709) Transistors mit einer gleichen zweiten Steuerleiterbahn (B2T_SEL) der globalen Kopplungsschaltung verbunden sind.

8. Speicherschaltung nach einem der Ansprüche 1 bis 7, mit einer Steuerschaltung, die in der Lage ist, im Lesemodus gleichzeitig eine erste Zelle einer Spalte vom Rang j eines ersten lokalen Arrays der Speicherschaltung und eine zweite Zelle einer Spalte vom gleichen Rang j eines zweiten lokalen Arrays der Speicherschaltung zu aktivieren und die Kopplungsschaltung(en) (31; 61) zu steuern, die die vertikale lokale Bitleitung (LRBL<j>; LRBLT<j>; LRBLT<j>) der Spalte vom Rang j des ersten lokalen Arrays mit der vertikalen lokalen Bitleitung (LRBL<j>; LRBLT<j>) der Spalte vom Rang j des zweiten lokalen Arrays koppelt bzw. koppeln, um über die vertikale lokale Bitleitung der Spalte vom Rang j des zweiten lokalen Arrays ein binäres Signal zu übertragen, das auf der vertikalen lokalen Bitleitung vom Rang j des ersten lokalen Arrays vorhanden ist, um eine logische Operation durchzuführen, die als Operanden die in den ersten und zweiten Zellen gespeicherten Daten hat.

9. Speicherschaltung einer der Ansprüche 1 bis 8, wobei:
jede Spalte jedes lokalen Arrays eine vertikale komplementäre lokale Bitleitung (LRBLF<j>) aufweist, die direkt mit jeder der Zellen in der Spalte verbunden ist;
jede Spalte jedes lokalen Arrays eine vertikale komplementäre globale Bitleitung (GRBLF<j>) aufweist, die mit der zweiten lokalen Bitleitung (LRBLF<j>) der Spalte durch eine lokale Kopplungsschaltung (31) gekoppelt ist, die steuerbar ist zum:
- Isolieren der vertikalen komplementären lokalen Bitleitung der vertikalen komplementären globalen Bitleitung,
- Übertragen, über die vertikale komplementäre globale Bitleitung, eines binären Signals, das auf der vertikalen komplementären lokalen Bitleitung vorhanden ist, oder
- Übertragen, über die vertikale komplementäre lokale Bitleitung, eines binären Signals, das auf der vertikalen komplementären globalen Bitleitung vorhanden ist;
in jeder Spalte vom Rang q des globalen Arrays, für jeden Spaltenrang j der lokalen Arrays, die K vertikalen komplementären globalen Bitleitungen (VGRBL<j>), die den gleichen Rang j haben, miteinander gekoppelt werden;
die Speicherschaltung ferner für jede Spalte jedes lokalen Arrays eine horizontale komplementäre globale Bitleitung (HGRBL<j>) aufweist, die mit der vertikalen komplementären globalen Bitleitung der Spalte verbunden ist; und
in jeder Zeile des Rangs I des globalen Arrays für jeden Spaltenrang j der lokalen Arrays die P horizontalen komplementären globalen Bitleitungen (HGRBL<j>) mit dem gleichen Rang j miteinander gekoppelt werden.

10. Speicherschaltung nach Anspruch 9, die ferner für jede Spalte jedes lokalen Arrays eine Zusatzschaltung (1001) aufweist, die mit der vertikalen lokalen Bitleitung, der vertikalen komplementären lokalen Bitleitung, der vertikalen globalen Bitleitung und der komplementären globalen Bitleitung der Spalte verbunden ist, wobei die Zusatzschaltung (1001) in der Lage ist, logische Rechenoperationen zu implementieren, die als Operanden binäre Daten haben, die an die vertikale lokale Bitleitung und an die vertikale komplementäre lokale Bitleitung der Spalte angelegt werden und die Ergebnisse dieser Operationen auf der vertikalen globalen Bitleitung und auf der komplementären globalen Bitleitung der Spalte zu liefern.

11. Speicherschaltung nach Anspruch 10, wobei die Zusatzschaltung (1001) Folgendes aufweist:
einen ersten Transistor (1102), der die vertikale globale Bitleitung (GRBLT<j>) mit einem ersten Zwischenknoten (n1) koppelt;
einen zweiten Transistor (1104), der einen zweiten Zwischenknoten (n2) mit einem Knoten zum Anlegen eines niedrigen Energieversorgungspotentials (GND) der Speicherschaltung verbindet;
einen dritten Transistor (1106), der die vertikale komplementäre globale Bitleitung (GRBLF<j>) mit einem dritten Zwischenknoten (n3) verbindet;
einen vierten Transistor (1108), der einen vierten Zwischenknoten (n4) mit dem Knoten des Anlegens des niedrigen Leistungsversorgungspotentials (GND) der Speicherschaltung verbindet;
einen ersten Schalter (S1), der den ersten Zwischenknoten (n1) mit dem zweiten Zwischenknoten (n2) koppelt;
einen zweiten Schalter (S2), der den dritten Zwischenknoten (n3) mit dem vierten Zwischenknoten (n4) koppelt;
einen dritten Schalter (S3), der den zweiten Zwischenknoten (n2) mit dem dritten Zwischenknoten (n3) koppelt; und
einen vierten Schalter (S4), der den ersten Zwischenknoten (n1) mit dem vierten Zwischenknoten (n4) koppelt.

12. Speicherschaltung nach Anspruch 11, wobei:
das Gate des dritten Transistors (1106) der Zusatzschaltung mit der vertikalen lokalen Bitleitung (LRBLT<j>) der Spalte gekoppelt ist;
das Gate des zweiten Transistors (1104) der Zusatzschaltung mit der vertikalen komplementären lokalen Bitleitung (LRBLF<j>) der Spalte gekoppelt ist;
das Gate des ersten Transistors (1102) der Zusatzschaltung mit einem Knoten (L̅R̅B̅L̅F̅<̅*̅j̅*̅>̅) gekoppelt ist, der ein Binärsignal liefert, das komplementär zu dem von der vertikalen lokalen Lesebitleitung (LRBLT<j>) der Spalte übertragenen Binärsignal ist; und
das Gate des vierten Transistors (1108) mit einem Knoten (L̅R̅B̅L̅F̅<̅*̅j̅*̅>̅) gekoppelt ist, der ein Binärsignal liefert, das komplementär zu dem Binärsignal ist, das von der vertikalen komplementären lokalen Lesebitleitung (LRBLF<j>) der Spalte übertragen wird.

13. Eine Speicherschaltung mit K*P*M*N Elementarzellen (10), die in K*P lokalen Arrays (A1, A2; A; A11, A12, A21, A22) verteilt sind, die jeweils M Zeilen und N Spalten aufweisen, wobei die K*P-Arrays in einem globalen Array von K Zeilen und P Spalten angeordnet sind, mit:
- K, P, M und N ganzen Zahlen größer oder gleich 2,
- l eine ganze Zahl im Bereich von 0 bis K-1 und q eine ganze Zahl im Bereich von 0 bis P-1, die jeweils den Rang der Zeile und den Rang der Spalte jedes lokalen Arrays im globalen Array bezeichnen,
- i eine ganze Zahl im Bereich von 0 bis M-1 und j eine ganze Zahl im Bereich von 0 bis N-1 ist, die den Rang der Zeile bzw. den Rang der Spalte jeder Elementarzelle (10) in dem lokalen Array, zu der sie gehört, bezeichnen, wobei
jede Spalte jeder lokalen Matrix eine vertikale lokale Bitleitung (LRBL<j>; LRBLT<j>; VLRBL<j>) aufweist, die direkt mit jeder der Zellen der Spalte verbunden ist;
jede Spalte jedes lokalen Arrays eine vertikale globale Bitleitung (VGRBL<j>) aufweist, die mit der vertikalen lokalen Bitleitung (LRBL<j>; LRBLT<j>; VLRBL<j>) der Spalte durch eine lokale Kopplungsschaltung (31) gekoppelt ist, wobei die lokale Kopplungsschaltung (31) steuerbar ist zum:
- Isolieren der vertikalen lokalen Bitleitung von der vertikalen globalen Bitleitung,
- Übertragen, über die vertikale globale Bitleitung, eines binären Signals, das auf der vertikalen lokalen Bitleitung vorhanden ist, oder
- Übertragen, über die vertikale lokale Bitleitung, eines binären Signals, das auf der vertikalen globalen Bitleitung vorhanden ist;
in jeder Spalte vom Rang q im globalen Array für jeden Spaltenrang j der lokalen Arrays die K vertikalen globalen Bitleitungen (VGRBL<j>), die den gleichen Rang j haben, miteinander gekoppelt werden;
**dadurch gekennzeichnet, dass**
jede Zeile jedes lokalen Arrays eine horizontale lokale Bitleitung (HLRBL<i>), die direkt mit jeder Zelle der Zeile verbunden ist, aufweist;
jede Zeile jedes lokalen Arrays eine horizontale globale Bitleitung (HGRBL<i>) aufweist, die mit der horizontalen lokalen Bitleitung (HLRBL<i>) der Zeile über eine lokale Kopplungsschaltung (31) gekoppelt ist, wobei die lokale Kopplungsschaltung (31) steuerbar ist zum:
- Isolieren der horizontalen lokalen Bitleitung von der horizontalen globalen Bitleitung,
- Übertragen, über die horizontale globale Bitleitung, eines binären Signals, das auf der horizontalen lokalen Bitleitung vorhanden ist, oder
- Übertragen, über die horizontale lokale Bitleitung, eines binären Signals, das auf der horizontalen globalen Bitleitung vorhanden ist;
in jeder Zeile des Rangs l im globalen Array für jeden Zeilenrang i der lokalen Arrays die P horizontalen globalen Bitleitungen (VGRBL<j>), die den gleichen Rang i haben, miteinander gekoppelt werden.

## Claims

1. A memory circuit comprising K*P*M*N elementary cells (10) distributed in K*P local arrays (A1, A2; A; A11, A12, A21, A22) each comprising M rows and N columns, the K*P arrays being arranged in a global array of K rows and P columns, with:
- K, P, M and N integers greater than or equal to 2,
- 1 integer in the range from 0 to K-1 and q integer in the range from 0 to P-1 designating respectively the rank of the row and the rank of the column of each local array in the global array,
- i integer in the range from 0 to M-1 and j integer in the range from 0 to N-1 designating respectively the rank of the row and the rank of the column of each elementary cell (10) in the local array to which it belongs, wherein:
each column of each local array comprises a vertical local bit line (LRBL<j>; LRBLT<j>; VLRBL<j>) directly connected to each of the cells in the column;
each column of each local array comprises a vertical global bit line (VGRBL<j>) coupled to the vertical local bit line (LRBL<j>; LRBLT<j>; VLRBL<j>) of the column by a local coupling circuit (31), the local coupling circuit (31) being controllable to:
- isolate the vertical local bit line from the vertical global bit line,
- transmit over the vertical global bit line a binary signal present on the vertical local bit line, or
- transmit over the vertical local bit line a binary signal present on the vertical global bit line;
in each column of rank q in the global array, for each column rank j of the local arrays, the K vertical global bit lines (VGRBL<j>) having the same rank j are coupled together;
**characterized in that** the memory circuit further comprises, for each column of each local array, an horizontal global bit line (HGRBL<j>) connected to the vertical global bit line of the column; and
in each row of rank 1 in the global array, for each column rank j of the local arrays, the P horizontal global bit lines (HGRBL<j>) having the same rank j are coupled together.

2. The memory circuit of claim 1, wherein, in each column of each local array, the local coupling circuit (31) comprises:
first (401) and second (403) transistors series-connected between a node (VDD) of application of a power supply voltage of the circuit and the vertical global bit line (VGRBL<j>) of the column; and
third (405) and fourth (407) transistors series-connected between the vertical local bit line (LRBL<j>; LRBLT<j>) of the column and a node (GND) of application of a reference potential of the circuit,
the gate of the second transistor (403) being connected to the vertical local bit line (LRBL<j>; LRBLT<j>) of the column and the gate of the third transistor (405) being connected to the vertical global bit line (VGRBL<j>) of the column.

3. The memory circuit of claim 1 or 2, wherein:
the local arrays (A1, A2) belong to a same memory module;
in each column of rank q of the global array, for each column rank j of the local arrays, the K vertical global bit lines (VGRBL<j>) having the same rank j are directly interconnected; and
in each row of rank 1 of the global array, for each column rank j of the local arrays, the P horizontal global bit lines (HGRBL<j>) having the same rank j are directly interconnected.

4. The memory circuit of claim 1 or 2, wherein:
the local arrays (A) belong to different memory modules;
in each column of rank q of the global array, for each column rank j of the local arrays, the K vertical global bit lines (VGRBL<j>) having the same rank j are coupled in series via K-1 global coupling circuits (61); and
in each row of rank 1 of the global array, for each column rank j of the local arrays, the P horizontal global bit lines (HGRBL<j>) having the same rank j are coupled in series via P-1 global coupling circuits (61).

5. The memory circuit of claim 4, wherein each global coupling circuit (61) coupling in series a first global bit line of a memory module to a second global bit line of a neighboring memory module is controllable to:
- isolate the first and second global bit lines from each other,
- copy onto the second global bit line a binary signal present on the first global bit line, or
- copy onto the first global bit line a binary signal present on the second global bit line.

6. The memory circuit of claim 5, wherein each global coupling circuit (61) comprises:
an amplifier (701) having an input coupled to the first global bit line by a fifth transistor (703) and an output coupled to the second global bit lines by a sixth transistor (705);
a seventh transistor (707) coupling the first global bit line to the output of the amplifier (701); and
an eighth transistor (709) coupling the second global bit line to the input of the amplifier (701).

7. The memory circuit of claim 6, wherein, in each global coupling circuit (61), the gates of the fifth (703) and sixth (705) transistors are connected to a same control conductive track (T2B_SEL) of the global coupling circuit, and the gates of the seventh (707) and eighth (709) transistors are connected to a same second control conductive track (B2T_SEL) of the global coupling circuit.

8. The memory circuit of any of claims 1 to 7, comprising a control circuit capable of simultaneously activating in read mode a first cell of a column of rank j of a first local array of the memory circuit, and a second cell of a column of same rank j of a second local array of the memory circuit, and of controlling the coupling circuit(s) (31; 61) coupling the vertical local bit line (LRBL<j>; LRBLT<j>) of the column of rank j of the first local array to the vertical local bit line (LRBL<j>; LRBLT<j>) of the column of rank j of the second local array, to transmit over the vertical local bit line of the column of rank j of the second local array a binary signal present on the vertical local bit line of rank j of the first local array, to perform a logic operation having as operands the data stored in the first and second cells.

9. The memory circuit of any of claims 1 to 8, wherein:
each column of each local array comprises a vertical complementary local bit line (LRBLF<j>) directly connected to each of the cells in the column;
each column of each local array comprises a vertical complementary global bit line (GRBLF<j>) coupled to the second local bit line (LRBLF<j>) of the column by a local coupling circuit (31) controllable to:
- isolate the vertical complementary local bit line of the vertical complementary global bit line,
- transmit over the vertical complementary global bit line a binary signal present on the vertical complementary local bit line, or
- transmit over the vertical complementary local bit line a binary signal present on the vertical complementary global bit line;
in each column of rank q of the global array, for each column rank j of the local arrays, the K vertical complementary global bit lines (VGRBL<j>) having the same rank j are coupled together;
the memory circuit further comprises, for each column of each local array, a horizontal complementary global bit line (HGRBL<j>) connected to the vertical complementary global bit line of the column; and
in each row of rank 1 of the global array, for each column rank j of the local arrays, the P horizontal complementary global bit lines (HGRBL<j>) having the same rank j are coupled together.

10. The memory circuit of claim 9, further comprising, for each column of each local array, an additional circuit (1001) connected to the vertical local bit line, to the vertical complementary local bit line, to the vertical global bit line and to the complementary global bit line of the column, the additional circuit (1001) being capable of implementing logic calculation operations having as operands binary data applied to the vertical local bit line and to the vertical complementary local bit line of the column and of supplying the results of these operations on the vertical global bit line and on the complementary global bit line of the column.

11. The memory circuit of claim 10, wherein the additional circuit (1001) comprises:
a first transistor (1102) coupling the vertical global bit line (GRBLT<j>) to a first intermediate node (n1);
a second transistor (1104) coupling a second intermediate node (n2) to a node of application of a low power supply potential (GND) of the memory circuit;
a third transistor (1106) coupling the vertical complementary global bit line (GRBLF<j>) to a third intermediate node (n3);
a fourth transistor (1108) coupling a fourth intermediate node (n4) to the node of application of the low power supply potential (GND) of the memory circuit;
a first switch (S1) coupling the first intermediate node (n1) to the second intermediate node (n2);
a second switch (S2) coupling the third intermediate node (n3) to the fourth intermediate node (n4);
a third switch (S3) coupling the second intermediate node (n2) to the third intermediate node (n3); and
a fourth switch (S4) coupling the first intermediate node (n1) to the fourth intermediate node (n4).

12. The memory circuit of claim 11, wherein:
the gate of the third transistor (1106) of the additional circuit is coupled to the vertical local bit line (LRBLT<j>) of the column;
the gate of the second transistor (1104) of the additional circuit is coupled to the vertical complementary local bit line (LRBLF<j>) of the column;
the gate of the first transistor (1102) of the additional circuit is coupled to a node (L̅R̅B̅L̅T̅<̅*̅j̅*̅>̅) supplying a binary signal complementary to the binary signal carried by the vertical local read bit line (LRBLT<j>) of the column; and
the gate of the fourth transistor (1108) is coupled to a node (L̅R̅B̅L̅F̅<̅*̅j̅*̅>̅) supplying a binary signal complementary to the binary signal carried by the vertical complementary local read bit line (LRBLF<j>) of the column.

13. A memory circuit comprising K*P*M*N elementary cells (10) distributed in K*P local arrays (A1, A2; A; A11, A12, A21, A22) each comprising M rows and N columns, the K*P arrays being arranged in a global array of K rows and P columns, with:
- K, P, M and N integers greater than or equal to 2,
- 1 integer in the range from 0 to K-1 and q integer in the range from 0 to P-1 designating respectively the rank of the row and the rank of the column of each local array in the global array,
- i integer in the range from 0 to M-1 and j integer in the range from 0 to N-1 designating respectively the rank of the row and the rank of the column of each elementary cell (10) in the local array to which it belongs, wherein:
each column of each local array comprises a vertical local bit line (LRBL<j>; LRBLT<j>; VLRBL<j>) directly connected to each of the cells in the column;
each column of each local array comprises a vertical global bit line (VGRBL<j>) coupled to the vertical local bit line (LRBL<j>; LRBLT<j>; VLRBL<j>) of the column by a local coupling circuit (31), the local coupling circuit (31) being controllable to:
- isolate the vertical local bit line from the vertical global bit line,
- transmit over the vertical global bit line a binary signal present on the vertical local bit line, or
- transmit over the vertical local bit line a binary signal present on the vertical global bit line;
in each column of rank q in the global array, for each column rank j of the local arrays, the K vertical global bit lines (VGRBL<j>) having the same rank j are coupled together;
**characterized in that**,
each row of each local array comprises an horizontal local bit line (HLRBL<i>) directly connected to each cell of the row ;
each row of each local array comprises an horizontal global bit line (HGRBL<i>) coupled to the horizontal local bit line (HLRBL<i> of the row via a local coupling circuit (31), the local coupling circuit (31) being controllable to:
- isolate the horizontal local bit line from the horizontal global bit line,
- transmit over the horizontal global bit line a binary signal present on the horizontal local bit line, or
- transmit over the horizontal local bit line a binary signal present on the horizontal global bit line;
in each row of rank 1 in the global array, for each row rank i of the local arrays, the P horizontal global bit lines (VGRBL<j>) having the same rank i are coupled together.
